(19) **Europäisches Patentamt**
**European Patent Office**
**Office européen des brevets**

(11) **EP 2 748 857 B1**

(12) **EUROPÄISCHE PATENTSCHRIFT**

(45) Veröffentlichungstag und Bekanntmachung des Hinweises auf die Patenterteilung:
**13.06.2018 Patentblatt 2018/24**

(21) Anmeldenummer: **12758475.3**

(22) Anmeldetag: **12.09.2012**

(51) Int Cl.:
**H01L 29/786** $^{(2006.01)}$

(86) Internationale Anmeldenummer:
**PCT/EP2012/067804**

(87) Internationale Veröffentlichungsnummer:
**WO 2013/050221 (11.04.2013 Gazette 2013/15)**

(54) **VERFAHREN ZUR HERSTELLUNG VON HOCHPERFORMANTEN UND ELEKTRISCH STABILEN, HALBLEITENDEN METALLOXIDSCHICHTEN, NACH DEM VERFAHREN HERGESTELLTE SCHICHTEN UND DEREN VERWENDUNG**

METHOD FOR PRODUCING HIGH-PERFORMING AND ELECTRICALLY STABLE SEMI-CONDUCTIVE METAL OXIDE LAYERS, LAYERS PRODUCED ACCORDING TO THE METHOD AND USE THEREOF

PROCÉDÉ DE FABRICATION DE COUCHES D'OXYDES MÉTALLIQUES SEMI-CONDUCTRICES À HAUTES PERFORMANCES ET ÉLECTRIQUEMENT STABLES, COUCHES FABRIQUÉES PAR CE PROCÉDÉ ET LEUR UTILISATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.10.2011 DE 102011084145**

(43) Veröffentlichungstag der Anmeldung:
**02.07.2014 Patentblatt 2014/27**

(73) Patentinhaber: **Evonik Degussa GmbH**
**45128 Essen (DE)**

(72) Erfinder:
• **STEIGER, Jürgen**
**Taipei City 111 (TW)**
• **PHAM, Duy Vu**
**46047 Oberhausen (DE)**
• **NEUMANN, Anita**
**45657 Recklinghausen (DE)**
• **MERKULOV, Alexey**
**45665 Recklinghausen (DE)**
• **HOPPE, Arne**
**44623 Herne (DE)**

(56) Entgegenhaltungen:
**WO-A1-2006/049791     US-A1- 2010 308 326**

• **OHYA Y ET AL: "FABRICATION OF ZINC OXIDE TRANSPARENT THIN-FILM TRANSISTOR WITH ZRO2 INSULATING LAYER BY SOL-GEL METHOD", JAPANESE JOURNAL OF APPLIED PHYSICS, THE JAPAN SOCIETY OF APPLIED PHYSICS, JAPAN SOCIETY OF APPLIED PHYSICS, TOKYO; JP, Bd. 44, Nr. 4A, 1. April 2005 (2005-04-01) , Seiten 1919-1922, XP001245802, ISSN: 0021-4922, DOI: 10.1143/JJAP.44.1919**
• **HONG D ET AL: "Transparent thin-film transistor exploratory development via sequential layer deposition and thermal annealing", THIN SOLID FILMS, ELSEVIER-SEQUOIA S.A. LAUSANNE, CH, Bd. 515, Nr. 4, 5. Dezember 2006 (2006-12-05), Seiten 2717-2721, XP025007668, ISSN: 0040-6090, DOI: 10.1016/J.TSF.2006.03.050 [gefunden am 2006-12-05] in der Anmeldung erwähnt**
• **SONG H P ET AL: "The growth of ZnO on bcc-In2O3 buffer layers and the valence band offset determined by X-ray photoemission spectroscopy", SOLID STATE COMMUNICATIONS, PERGAMON, GB, Bd. 150, Nr. 41-42, 1. November 2010 (2010-11-01), Seiten 1991-1994, XP027491192, ISSN: 0038-1098, DOI: 10.1016/J.SSC.2010.08.022 [gefunden am 2010-08-27] in der Anmeldung erwähnt**

**Beschreibung**

**Gebiet der Erfindung**

Die vorliegende Erfindung betrifft ein Verfahren zur Herstellung eines Halbleiterlaminats, das eine erste und eine zweite Metalloxid-Schicht und eine Dielektrikum-Schicht umfasst, wobei die erste Metalloxid-Schicht zwischen der zweiten Metalloxid-Schicht und der Dielektrikum-Schicht angeordnet ist. Die erste und die zweite Metalloxid-Schicht werden entsprechend aus einer ersten und einer zweiten flüssigen Phase ausgebildet. Ebenfalls betrifft die vorliegende Erfindung ein Halbleiterlaminat, das nach einem solchen Verfahren erhältlich ist sowie elektronische Bauteile, die ein solches Halbleiterlaminat umfassen.

**Hintergrund der Erfindung**

Halbleitende Metalloxide, wie z.B. ZnO, $In_2O_3$ und $SnO_2$, sind in der Literatur gut bekannt. Sie verfügen über hohe Ladungsträgerbeweglichkeiten bei gleichzeitiger optischer Transparenz. In der kommerziellen Nutzung werden halbleitende Metalloxide derzeit entweder mittels Sputtering oder anderen Abscheidungsmethoden aus der Gasphase aufgebracht.

JP2007-073704 lehrt einen Aufbau von oxidischen Halbleiterbauteilen, bei dem verschiedene Oxidschichten mittels Sputtering hintereinander aufgebracht werden.

Hong et al. (Thin Solid Films (2006) 515: 2717-2721), lehren das mehrmalige, nacheinander folgende Aufbringen von einzelnen dünnen Oxidschichten mit jeweils einem Typ Metallatom mittels Sputtering-Verfahren.

Song et al. (Solid State Communications (2010) 150 : 1991-1994) lehren das Aufbringen von einer Zinkoxid-Schicht auf einer Indiumoxid-Schicht mittels metallorganischer chemischer Gasphasenabscheidung (engl. metal organic chemical vapor deposition, MOCVD).

Kumomi et al. (Journal of Display Technology (2009) 5 (12) :531-540) diskutieren das System In-X-O mit verschiedenen Elementen X. Die In-X-O Schicht wird mittels Co-Sputtering aufgebracht.

Diese Methoden sind nachteilig, da sie technisch aufwendig und mit hohen Kosten in der Anschaffung der dazu verwendeten Geräte verbunden sind.

Aus diesem Grund werden in der Literatur verstärkt Flüssigphasen-Beschichtungsmethoden diskutiert. In diesen Verfahren werden beispielsweise Oxid-Nanopartikel in einer Dispersion oder Präkursor-Moleküle in einem Lösungsmittel als flüssige Phasen eingesetzt. Schichten, die aus flüssiger Phase hergestellt werden, unterscheiden sich jedoch in mehreren Punkten von denen, die aus der Gasphase hergestellt wurden, da aufgrund der Verwendung von Lösungsmitteln oft Reste dieser Lösungsmittelmoleküle in die Schicht eingebaut sind. Zusätzlich ist, beispielsweise bei Präkursorlösungen, die chemische Umwandlung in das Oxid nicht immer einheitlich.

Ein bekanntes Problem bei halbleitenden Metalloxiden mit nur einem Typ Metallatom, unabhängig davon mit welchem Verfahren sie hergestellt worden sind, ist die mangelnde Stabilität sowohl gegenüber atmosphärischen Einflüssen, als auch die - kommerziell besonders wichtige - Stabilität gegenüber elektrischem Stress.

Eine Lösung dieses Problems ist die Verwendung von komplexeren Metalloxiden mit zwei oder mehr verschiedenen Typen von Metallatomen. In der Sputter- bzw. Aufdampftechnologie werden deshalb bevorzugt Systeme wie Indium-Gallium-Zink-Oxid eingesetzt, da sie besonders stabil sind. Aber auch in Flüssigphasen-Systemen wurde dieser Ansatz aufgegriffen.

WO2010/122274 A1 lehrt den Aufbau von besonders stabilen Bauteilen aus Lösung durch das Einbringen von Alkali- oder Erdalkalimetallatomen in die Schicht

Kim et al. (APPLIED PHYSICS LETTERS (2010) 96: 163506), lehren die Flüssigphase-basierte Herstellung von stabilen Bauteilen durch das Einmischen von Mg Metallatomen in die Halbleiterschicht.

US 2006-0088962 A1 lehrt das Aufbringen von oxidischen Dielektrika aus Lösung auf ein Halbleiterbauelement zur Verbesserung der Halbleitereigenschaften.

WO 2006/049791 A1 (HEWLETT PACKARD DEVELOPMENT CO [US]; HOFFMAN RANDY [US]; MARDILOVICH P) 11. Mai 2006 und OHYA Y ET AL: "FABRICATION OF ZINC OXIDE TRANSPARENT THIN-FILM TRANSISTOR WITH ZRO2 INSULATING LAYER BY SOL-GEL METHOD",JAPANESE JOURNAL OF APPLIED PHYSICS, Bd. 44, Nr. 4A, 1. April 2005 (2005-04-01), Seiten 1919-1922 lehren Halbleiterlaminate, bei denen eine erste Metalloxidschicht und eine zweite Metalloxidschicht jeweils aus der flüssigen Phase ausgebildet werden.

Dennoch lassen sich in den bekannten Verfahren, besonders bei Lösungen oder Dispersionen, die für optimale Oxidschichtbildung bei vergleichsweise niedrigen Umwandlungstemperaturen optimiert wurden, nicht ohne Weiteres andere Metallatome zufügen, ohne Nachteile in Kauf nehmen zu müssen. Nachteile sind beispielsweise eine chemische Reaktion mit der Ursprungslösung, eine Störung der Schichtbildung oder ein ungleichmäßiges stöchiometrisches Verhältnis der Metallatome auf der Oberfläche. In diesen Fällen bringen die gewünschten Vorteile hinsichtlich der elektrischen Stabilität gleichzeitig Nachteile mit sich, z. B. eine Reduktion der Ladungsträgerbeweglichkeit in der Halbleiterschicht.

Die vorliegende Erfindung überwindet die bekannten Nachteile.

**Zusammenfassung der Erfindung**

Die vorliegende Erfindung betrifft ein Verfahren zur Herstellung eines Halbleiterlaminats umfassend eine erste Metalloxid-Schicht, eine zweite Metalloxid-Schicht und eine Dielektrikum-Schicht, wobei die erste Metalloxid-Schicht zwischen der zweiten Metalloxid-Schicht und der Dielektrikum-Schicht angeordnet ist, wobei das Verfahren (i) das Ausbilden einer ersten Metalloxid-Schicht enthaltend mindestens ein Metalloxid ausgewählt aus der Gruppe bestehend aus Indiumoxid, Galliumoxid, Zinkoxid, Zinnoxid oder Mischungen davon aus einer ersten flüssigen Phase, wobei die erste Metalloxid-Schicht eine Schichtdicke von $\leq 20$ nm aufweist und die erste flüssige Phase mindestens ein Metalloxid oder mindestens einen Metalloxid-Präkursor enthält, wobei das Metalloxid ausgewählt wird aus der Gruppe bestehend aus Indiumoxid, Galliumoxid, Zinkoxid, Zinnoxid oder Mischungen davon, und (ii) das Ausbilden einer zweiten Metalloxid-Schicht enthaltend mindestens ein Metalloxid ausgewählt aus der Gruppe bestehend aus Galliumoxid, Zinkoxid, Zinnoxid, Hafniumoxid, Siliziumoxid, Aluminiumoxid, Titanoxid, Alkalimetalloxiden, Erdalkalimetalloxiden oder Mischungen davon aus einer zweiten flüssigen Phase, wobei die zweite flüssige Phase mindestens ein Metalloxid oder mindestens einen Metalloxid-Präkursor enthält, wobei das Metalloxid ausgewählt wird aus der Gruppe bestehend aus Galliumoxid, Zinkoxid, Zinnoxid, Hafniumoxid, Siliziumoxid, Aluminiumoxid, Titanoxid, Alkalimetalloxiden, Erdalkalimetalloxiden oder Mischungen davon, umfasst, und wobei das mindestens eine Metalloxid der ersten Schicht und das mindestens eine Metalloxid der zweiten Schicht unterschiedlich sind.

In verschiedenen Ausführungsformen des Verfahrens weist die erste Metalloxid-Schicht eine Schichtdicke von 0,5-20 nm auf.

In einigen Ausführungsformen des Verfahrens weist die zweite Metalloxid-Schicht mindestens die Schichtdicke der ersten Metalloxid-Schicht auf.

In weiteren Ausführungsformen des Verfahrens umfasst die zweite Metalloxid-Schicht mindesten ein Metalloxid, das nicht in der ersten Metalloxid-Schicht enthalten ist.

In bestimmten Ausführungsformen des Verfahrens umfasst die zweite Metalloxid-Schicht mindestens zwei Metalloxide.

In verschiedenen Ausführungsformen des Verfahrens umfasst die erste Metalloxid-Schicht mindestens zwei Metalloxide.

In weiteren Ausführungsformen des Verfahrens umfasst die zweite Metalloxid-Schicht Siliziumoxid.

In einigen Ausführungsformen des Verfahrens besteht die erste Metalloxid-Schicht im Wesentlichen aus Indiumoxid ($In_2O_3$) oder Indium-Gallium-Oxid, d.h. die erste Metalloxid-Schicht weist im Falle von Indiumoxid Indium zu mindestens 51 Gew.-% und im Falle von Indium-Gallium-Oxid die Metalle Indium und Gallium gemeinsam zu mindestens 51 Gew.-%, jeweils bezogen auf die Massenanteile der anwesenden Metalle in der Schicht, auf.

In bestimmten Ausführungsformen des Verfahrens besteht die zweite Metalloxid-Schicht im Wesentlichen, d.h. zu mindestens 51 Gew.-%, bezogen auf die Massenanteile aller anwesenden Metalle in der Schicht, aus ZnO, $Ga_2O_3$, $HfO_2$, $SiO_2$, Silizium-Gallium-Oxid oder Silizium-Hafnium-Oxid.

In verschiedenen Ausführungsformen des Verfahrens umfasst das Ausbilden der ersten Metalloxid-Schicht das Aufbringen der ersten flüssigen Phase auf die Dielektrikum-Schicht und das Abscheiden des mindestens einen Metalloxids oder des mindestens einen Metalloxid-Präkursors der ersten flüssigen Phase auf der Dielektrikum-Schicht, um die erste Metalloxid-Schicht auf der Dielektrikum-Schicht auszubilden. In diesen Ausführungsformen umfasst das Ausbilden der zweiten Metalloxid-Schicht das Aufbringen der zweiten flüssigen Phase auf die erste Metalloxid-Schicht, und das Abscheiden des mindestens einen Metalloxids oder des mindestens einen Metalloxid-Präkursors der zweiten flüssigen Phase auf der ersten Metalloxid-Schicht, um die zweite Metalloxid-Schicht auf der ersten Metalloxid-Schicht auszubilden.

In anderen Ausführungsformen des Verfahrens umfasst das Ausbilden der zweiten Metalloxid-Schicht das Aufbringen der zweiten flüssigen Phase auf ein Substrat und das Abscheiden des mindestens einen Metalloxids oder des mindestens einen Metalloxid-Präkursors der zweiten flüssigen Phase auf dem Substrat, um die zweite Metalloxid-Schicht auf dem Substrat auszubilden. In diesen Ausführungsformen umfasst das Ausbilden der ersten Metalloxid-Schicht das Aufbringen der ersten flüssigen Phase auf die zweite Metalloxid-Schicht und das Abscheiden des mindestens einen Metalloxids oder der mindestens einen Metalloxid-Präkursors der ersten flüssigen Phase auf der zweiten Metalloxidschicht, um die erste Metalloxid-Schicht auf der zweiten Metalloxid-Schicht auszubilden, und das Aufbringen der Dielektrikum-Schicht auf die erste Metalloxid-Schicht.

In verschiedenen Ausführungsformen des Verfahrens werden die erste und/oder die zweite flüssige Phase durch Verfahren aufgebracht, die ausgewählt werden aus der Gruppe bestehend aus Druckverfahren, Sprühverfahren, Rotationsbeschichtungsverfahren, Tauchverfahren und Slot-Die Coating.

In weiteren Ausführungsformen des Verfahrens stammt der mindestens eine Metalloxid-Präkursor der ersten und/oder zweiten flüssigen Phase aus der Klasse der Metall-Alkoxide und/oder Metall-Oxoalkoxide.

In verschiedenen Ausführungsformen des Verfahrens umfassen die erste und/oder die zweite flüssige Phase mindestens ein organisches Lösungsmittel.

In weiteren Ausführungsformen des Verfahrens umfassen die erste und/oder die zweite flüssige Phase mindestens ein organisches Lösungsmittel, wobei das organische Lösungsmittel im Wesentlichen wasserfrei ist. Unter einem im Wesentlichen wasserfreien Lösemittel ist dabei ein Lösemittel zu verstehen, dass maximal 500 ppm Wasser aufweist.

In einigen Ausführungsformen des Verfahrens umfassen die erste und/oder die zweite flüssige Phase mindestens ein Metalloxid in Form eines Metalloxid-Partikels.

In diversen Ausführungsformen des Verfahrens umfassen die erste und/oder die zweite flüssige Phase eine wässrige Phase.

In weiteren Ausführungsformen des Verfahrens umfasst das Ausbilden der ersten und/oder zweiten Metalloxid-Schicht ferner eine Wärmebehandlung der ersten und/oder zweiten flüssigen Phase.

In einigen Ausführungsformen des Verfahrens umfasst das Ausbilden der ersten und/oder zweiten Metalloxid-Schicht die Bestrahlung der ersten und/oder zweiten flüssigen Phase mit elektromagnetischer Strahlung, insbesondere UV-, IR-, und/oder VIS-Strahlung. In einer bestimmten Ausführungsform wird beispielsweise vor, nach oder während einer Wärmebehandlung der ersten und/oder zweiten flüssigen Phase die erste und/oder zweite flüssigen Phase mit UV-Strahlung bestrahlt.

In weiteren Ausführungsformen des Verfahrens werden die erste und/oder die zweite Metalloxid-Schicht unter sauerstoffhaltiger Atmosphäre, insbesondere Luft ausgebildet.

In verschiedenen Ausführungsformen des Verfahrens werden die erste und/oder die zweite Metalloxid-Schicht bei einer Temperatur von 100-450°C, bevorzugt bei 150-350 °C wärmebehandelt.

In einigen Ausführungsformen des Verfahrens weist die erste Metalloxid-Schicht eine Schichtdicke von 0,5-10 nm, bevorzugt von 2-5 nm auf.

In einem weiteren Aspekt betrifft die vorliegende Erfindung ein Halbleiterlaminat, das nach einem Verfahren der vorliegenden Erfindung hergestellt wird.

Ferner umfasst die vorliegende Erfindung ein elektronisches Bauteil, das ein Halbleiterlaminat der vorliegenden Erfindung umfasst.

Ebenfalls Teil der vorliegenden Erfindung ist ein elektronisches Bauteil, das ein Halbleiterlaminat der vorliegenden Erfindung umfasst, wobei das elektronische Bauteil ein Transistor, ein Dünnschichttransistor, eine Diode, eine Solarzelle, ein Sensor, ein RFID-Tag oder ein TFT-Backpanel für Bildschirme ist.

## Beschreibung der Abbildungen

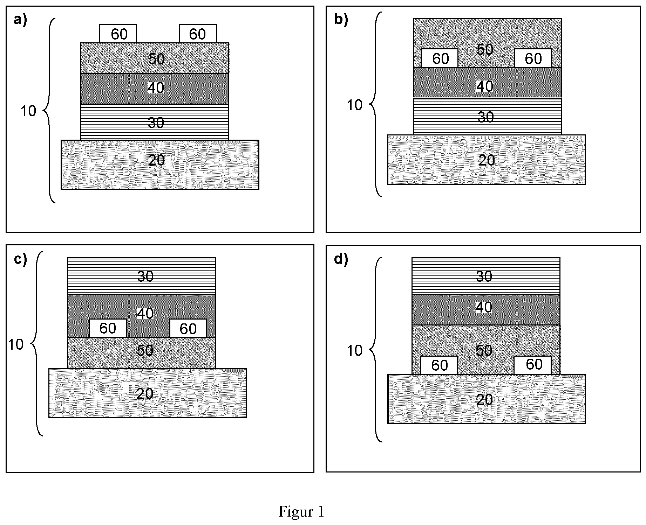

Figur 1 zeigt beispielhaft den schematischen Aufbau von aus dem Stand der Technik bekannten Halbleiterelementen (10). Diese Elemente umfassen ein Substrat (20), eine Gate-Elektrode (30), eine Dielektrikum-Schicht (40), eine aktive, halbleitende Metalloxidschicht (50) und Elektrodenkontaktstellen (60). Die jeweiligen Konfigurationen der Halbleiter-Bauelemente (10) unterscheiden sich in der relativen Anordnung der Halbleiterschicht (50) zu der Dielektrikum-Schicht (40) und dem Substrat (20) sowie in der Position der Elektrodenkontaktstellen (60). Die Bauelemente werden entsprechend ihrer Konfiguration wie folgt bezeichnet a) Bottom-Gate-Top-Contact (BGTC), b) Bottom-Gate- Bottom-Contact (BGBC), c) Top-Gate-Top-Contact (TGTC) und Top-Gate-Bottom-Contact (TGBC).

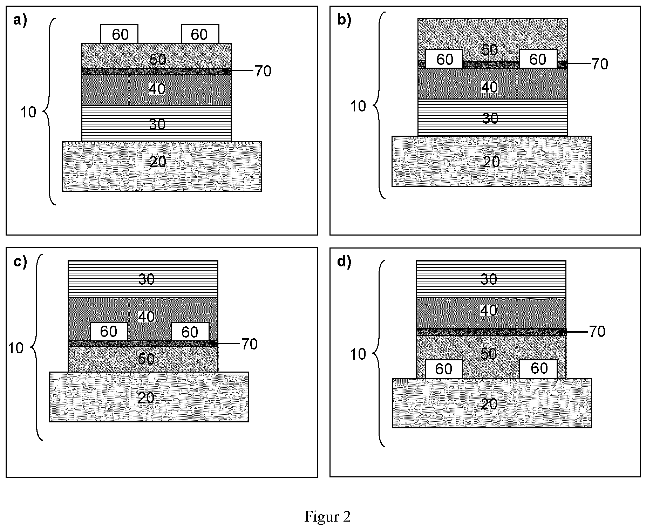

Figur 2 zeigt beispielhaft den Aufbau von Halbleiterelementen (10), die Halbleiterlaminate gemäß der vorliegenden Erfindung enthalten. Die vier dargestellten beispielhaften Varianten a)-d) umfassen eine aktive, halbleitende erste Metalloxid-Schicht (70), die zwischen einer zweiten Metalloxid-Schicht (40) und der Dielektrikum-Schicht (40) angeordnet ist, und unterscheiden sich in der relativen Anordnung der erste Metalloxid-Schicht (70) zur Gate-Elektrode (30) und dem Substrat (20) sowie in der Position der Elektrodenkontaktstellen (60).

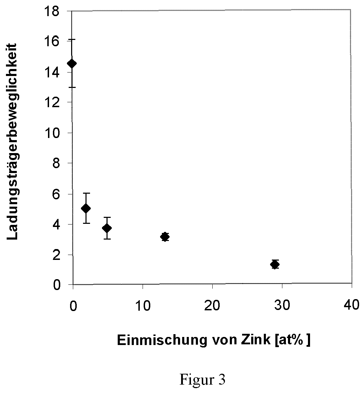

Figur 3 zeigt die Ergebnisse einer Untersuchung einer Halbleiterschicht, die erhalten wurde nachdem zu einer Indium-Präkursor enthaltenden flüssigen Phase verschiedene Mengen an Zink-Präkursor (X-Achse) gegeben wurden und die flüssige Phase wärmebehandelt wurde. Die erhaltene Halbleiterschicht wurde auf Ihre Ladungsträgerbeweglichkeit (Y-Achse) hin untersucht.

## Detaillierte Beschreibung der Erfindung

Wie eingangs beschrieben, sind Verfahren zur Halbleiterherstellung durch Gasabscheidung aufwendig und kostenintensiv. Es ist daher Ziel der gegenwärtigen Halbleiter-Forschung, Flüssigphasen-Verfahren zur Herstellung geeigneter Halbleiter zu entwickeln, da solche Verfahren technisch einfach zu implementieren und kostengünstiger sind. Bisher ist der Einsatz solcher Verfahren dadurch beschränkt, dass sich mit diesen Verfahren nur Halbleiter mit mangelnder elektrischer Stabilität herstellen lassen.

Im Stand der Technik wird das Problem der mangelnden elektrischen Stabilität von Halbleitern, die mittels Flüssigphasen-Verfahren hergestellt wurden, durch das Einbringen von Fremdmetallatomen in die Halbleiterschicht gelöst. Beispielsweise soll dadurch verhindert werden, dass Sauerstoff aus dem Halbleiter entweicht.

Diese Lösung hat den Nachteil, dass sie die grundlegende Leistungsfähigkeit des Bauteils in der Regel negativ beeinflusst. Insbesondere wird durch das Einbringen von Fremdatomen in die Halbleiterschicht die Ladungsträgerbeweglichkeit vermindert.

Die Erfinder der vorliegenden Erfindung haben nun überraschend herausgefunden, dass besonders dünne Metalloxid-Schichten mit einer Dicke $\leq 20$ nm, die in einem Halbleiterlaminat zwischen einer zweiten Metalloxid-Schicht und einer Dielektrikum-Schicht liegen, besondere Vorteile hinsichtlich ihrer Leistungsfähigkeit aufweisen.

Ohne an eine bestimmte Theorie gebunden zu sein, wird angenommen, dass die dünne Metalloxid-Schicht durch geringe Mengen von Metallatomen der zweiten Metalloxid-Schicht dotiert wird, wodurch bei gleichbleibender Ladungsträgerbeweglichkeit eine deutlich verbesserte Stabilität erzielt wird.

Somit weist ein solches Halbleiterlaminat eine elektrische Stabilität auf, die vergleichbar ist zu Halbleiterschichten, die dadurch hergestellt werden, dass in der flüssigen Phase Fremdatome eingebracht werden. Im Gegensatz zu den bekannten Verfahren erfolgt die Erhöhung der Stabilität im vorliegenden Verfahren aber nicht auf Kosten eines Verlusts an Ladungsträgerbeweglichkeit, weshalb Halbleiterlaminate der vorliegenden Erfindung eine gegenüber dem Stand der Technik verbesserte Ladungsträgerbeweglichkeit aufweisen. Daher werden durch das beanspruchte Verfahren neuartige hochperformante Halbleiterlaminate erzeugt.

In einem ersten Aspekt betrifft die vorliegende Erfindung daher ein Flüssigphasen-Verfahren zur Herstellung eines Halbleiterlaminats, wobei das Halbleiterlaminat eine erste Metalloxid-Schicht, eine zweite Metalloxid-Schicht und eine Dielektrikum-Schicht umfasst, wobei die erste Metalloxid-Schicht zwischen der zweiten Metalloxid-Schicht und der Dielektrikum-Schicht angeordnet ist, und wobei das Verfahren umfasst: (i) Ausbilden einer ersten Metalloxid-Schicht enthaltend mindestens ein Metalloxid ausgewählt aus der Gruppe bestehend aus Indiumoxid, Galliumoxid, Zinkoxid, Zinnoxid oder Mischungen davon aus einer ersten flüssigen Phase, wobei die erste Metalloxid-Schicht eine Schichtdicke von $\leq 20$ nm aufweist und die erste flüssige Phase mindestens ein Metalloxid oder mindestens einen Metalloxid-Präkursor enthält, wobei das Metalloxid ausgewählt wird aus der Gruppe bestehend aus Indiumoxid, Galliumoxid, Zinkoxid, Zinnoxid oder Mischungen davon; und

(ii) Ausbilden einer zweiten Metalloxid-Schicht enthaltend mindestens ein Metalloxid ausgewählt aus der Gruppe bestehend aus Galliumoxid, Zinkoxid, Zinnoxid, Hafniumoxid, Siliziumoxid, Aluminiumoxid, Titanoxid, Alkalimetalloxiden, Erdalkalimetalloxiden oder Mischungen davon aus einer zweiten flüssigen Phase, wobei die zweite flüssige Phase mindestens ein Metalloxid oder mindestens einen Metalloxid-Präkursor enthält, wobei das Metalloxid ausgewählt wird aus der Gruppe bestehend aus Galliumoxid, Zinkoxid, Zinnoxid, Hafniumoxid, Siliziumoxid, Aluminiumoxid, Titanoxid, Alkalimetalloxiden, Erdalkalimetalloxiden oder Mischungen davon;

wobei das mindestens eine Metalloxid der ersten Schicht und das mindestens eine Metalloxid der zweiten Schicht unterschiedlich sind.

Dies bedeutet, dass sich die erste und die zweite Metalloxid-Schicht in mindestens einem Metalloxid unterscheiden. Weitere Metalloxide, die die beiden Schichten enthalten können, können identisch und/oder verschieden sein.

In dem erfindungsgemäßen Verfahren werden die erste und die zweite Metalloxid-Schicht nacheinander ausgebildet, wobei die konkrete Reihenfolge von der gewünschten Konfiguration des Halbleiterelements abhängt.

In verschiedenen Ausführungsformen werden die Alkalimetalloxide ausgewählt aus der Gruppe bestehend aus Lithiumoxid, Natriumoxid, Kaliumoxid, Rubidiumoxid und Cäsiumoxid.

Die Erdalkalimetalloxide werden beispielsweise ausgewählt aus der Gruppe bestehend aus Berylliumoxid, Magnesiumoxid, Calciumoxid, Strontiumoxid und Bariumoxid.

Im erfindungsgemäß herstellbaren Halbleiterlaminat weist die halbleitende erste Metalloxid-Schicht eine Ladungsträgerbeweglichkeiten zwischen 1 und 100 cm$^2$/Vs (gemessen bei 50 V Gate-Source-Spannung, 50 V Drain-Source-Spannung, 1 cm Kanalbreite und 20 $\mu$m Kanallänge) auf, wobei diese über das Modell der "Gradual Channel Approximation" bestimmt werden können. Hierzu werden die von klassischen MOSFETs bekannten Formeln verwendet. Im linearen Bereich gilt:

$$I_D = \frac{W}{L} C_i \mu \left( U_{GS} - U_T - \frac{U_{DS}}{2} \right) U_{DS} \qquad (1)$$

wobei ID der Drain-Strom, UDs die Drain-Source-Spannung, UGs die Gate-Source-Spannung, C/ die flächennormierte Kapazität des Isolators, W die Breite des Transistorkanals, L die Kanallänge des Transistors, $\mu$ die Ladungsträgerbeweglichkeit und UT die Schwellenspannung sind.

Im Sättigungsbereich gilt eine quadratische Abhängigkeit zwischen Drain-Strom und Gate-Spannung, die vorliegend zur Bestimmung der Ladungsträgerbeweglichkeit verwendet wird:

$$I_D = \frac{W}{2L} C_i \mu (U_{GS} - U_T)^2 \qquad (2)$$

Unter dem Begriff "Metalloxid-Präkursor" im Sinne der vorliegenden Erfindung wird ein Stoff oder eine Verbindung verstanden, die thermisch oder mit elektromagnetischer Strahlung, in An- oder Abwesenheit von Sauerstoff oder anderen Oxidationsmitteln, in ein Metalloxid umgewandelt werden kann. Beispiele für Metalloxid-Präkursoren sind elementares Metall, Metallsalze, metallorganische Verbindungen, wie zum Beispiel Metall-Alkoxide und Metall-Oxoalkoxide, die der Fachmann in das korrespondierende Metalloxid überführen kann.

Der Begriff "Halbleiterlaminat" im Sinne der vorliegenden Erfindung betrifft ein Laminat, das aus mindestens drei Schichten besteht, einer ersten und einer zweiten Metalloxid-Schicht sowie einer Dielektrikum-Schicht. Der Begriff "Dielektrikum-Schicht" bezeichnet eine Schicht, die aus dielektrischem Material besteht. Eine solche Schicht wirkt bei der Arbeitstemperatur eines Halbleiterlaminats als Isolator. Bei dem dielektrischen Material, das bei dem erfindungsgemäßen Verfahren zur Ausbildung der Dielektrikum-Schicht verwendet wird, handelt es sich bevorzugt um ein Material, das ein Metall- oder Übergangsmetalloxid oder -nitrid, insbesondere Siliziumoxid oder -nitrid, Aluminiumoxid, Hafniumoxid, Titanoxid, ein organisches oder anorganisches Polymer enthält oder daraus besteht. Durch die Anordnung der ersten und zweiten Metalloxid-Schicht relativ zu der Dielektrikum-Schicht erhält das erfindungsgemäße Halbleiterlaminat eine Orientierung. In bestimmten Ausführungsformen schließt sich der Dielektrikum-Schicht eine Gate-Elektrode an, die somit auf der der ersten Metalloxid-Schicht gegenüberliegenden Seite liegt. In einigen Ausführungsformen schließt sich an die Gate-Elektrode ein Substrat an. In manchen Ausführungsformen schließt sich an die zweite Metalloxid-Schicht ein Substrat an. Ebenfalls kann das Halbleiterlaminat Elektrodenkontakte umfassen, die an der ersten und/oder zweiten Metalloxid-Schicht anliegen. An den Elektrodenkontakten können Quell- und Senk-Elektroden (Source und Drain) angeschlossen sein. Verschiedene nicht einschränkende Ausführungsformen des beanspruchten Halbleiterlaminats in einem Halbleiterelement werden in Figur 2 illustriert.

Unter dem Begriff "Metall" werden hierin sowohl Metalle als auch als Halbmetalle und Übergangsmetalle verstanden. Dementsprechend betrifft der Begriff "Metalloxid" Oxide von Metallen, Halbmetallen und Übergangsmetallen.

Die Begriffe "Alkalimetall" und/oder "Erdalkalimetall", wie hierin verwendet, umfassen und offenbaren daher alle Metalle, die in diese Gruppe fallen. Dies bedeutet, dass wenn eine bestimmte Ausführungsform ein Alkalimetall und/oder Erdalkalimetall umfasst, Lithium, Natrium, Kalium, Rubidium und/oder Cäsium als Alkalimetall und Beryllium, Magnesium, Calcium, Strontium und/oder Barium als Erdalkalimetall offenbart werden.

Unter dem Begriff "Metalloxid-Schicht" wird eine Metalloxid-, Halbmetalloxid- und/oder Übergangsmetalloxid-haltige Schicht verstanden. Somit weist die erste Metalloxid-Schicht beispielsweise Indium-, Gallium-, Zinn- und/oder Zinkatome bzw. -ionen auf, die oxidisch oder im Wesentlichen oxidisch vorliegen. Gegebenenfalls kann die Metalloxid-Schicht auch noch Anteile aus einer nicht vollständigen Konvertierung oder einer unvollständigen Entfernung entstehender Nebenprodukte aufweisen. So kann die Metalloxid-Schicht z.B. noch Carben-, Halogen-, Alkoxid- und/oder Oxoalkoxid-Verbindungen aufweisen. Ebenfalls können die erste und/oder zweite Metalloxid-Schicht noch weitere Metalle aufweisen, die in elementarer oder oxidischer Form vorliegen können.

Der Begriff "im Wesentlichen aus" im Sinne der vorliegenden Erfindung bedeutet, dass das derart bezeichnete Produkt oder Material zu 60%, 70 %, 80 %, 90 %, 95 %, 99 %, 99,5 % oder 99,9 % aus dem genannten Stoff oder der genannten Verbindung besteht. Wenn es sich um eine Metalloxid-Schicht handelt, die näher beschrieben wird, dann sind die Prozentangaben als Gew.-% zu verstehen. Wenn eine flüssige Phase oder Atmosphäre beschrieben wird, dann sind die Prozentangaben als Vol.-% zu verstehen. Der Begriff "Substrat" betrifft eine Schicht, die als Träger für das Halbleiterlaminat fungiert. Das Substrat umfasst bevorzugt ein Material ausgewählt aus Glas, Silizium, Siliziumdioxid, einem Metall- oder Übergangsmetalloxid, einem Metall, einem polymeren Material, insbesondere Polyimid (PI), Polyethylenterephthalat (PET), Polymethylmethacrylat (PMMA) oder Polycarbonat und einem Hybridsubstrat aus anorganischen und organischen Bestandteilen, insbesondere Siliziumoxid und Polyimid.

Unter dem Begriff "flüssige Phase" werden im Sinne der vorliegenden Erfindung solche Phasen verstanden, die bei SATP-Bedingungen ("Standard Ambient Temperature and Pressure"; T = 25 °C und p = 1013 hPa) in flüssiger Form vorliegen.

"Wasserfreie" Zusammensetzungen im Sinne der vorliegenden Erfindung sind solche, die weniger als 500 ppm $H_2O$ aufweisen. Entsprechende Trocknungsschritte, die zur Einstellung entsprechend niedriger Wassergehalte der Lösemittel führen, sind dem Fachmann bekannt.

Der Begriff "Ausbilden einer Metalloxid-Schicht aus der ersten und/oder zweiten flüssigen Phase" kann in verschiedene Stadien eingeteilt werden. In einem ersten Schritt kann aus der ersten und/oder zweiten flüssigen Phase eine erste und/oder zweite feste Phase ausgebildet werden. In dem nachfolgenden Schritt wird eine erste und/oder zweite Metalloxid-Schicht gemäß der vorliegenden Erfindung ausgebildet. In bestimmten Ausführungsformen verlaufen beider Schritte gleichzeitig. Wenn beispielsweise die erste und/oder zweite flüssige Phase mindestens ein Metalloxid enthält, dann entsteht beim Ausbilden der festen Phase eine Metalloxid-Schicht.

Die Ausbildung einer ersten und/oder zweiten Metalloxid-Schicht aus der ersten und/oder zweiten flüssigen Phase kann in manchen Ausführungsformen einen Wärmebehandlungsschritt-Schritt umfassen.

Eine Wärmebehandlung der ersten und/oder zweite flüssige Phase kann dazu dienen, die erste und/oder zweite flüssige Phase zu trocken. Eine solche Wärmebehandlung kann bei 50-450 °C erfolgen und kann dazu dienen, aus der ersten und/oder zweiten flüssigen Phase eine erste und/oder zweite feste Phase auszubilden.

Je nachdem, ob die erste und/oder zweite flüssige Phase mindestens ein Metalloxid oder mindestens einen Metalloxid-Präkursor umfassen, kann dadurch direkt eine Metalloxid-Schicht oder zunächst eine feste Phase aus Metalloxid-Präkursor gebildet werden. In Abhängigkeit der gewählten Bedingungen, insbesondere der Atmosphäre, Temperatur und Zeitspanne der Wärmebehandlung, kann eine flüssige Phase, die mindestens einen Metalloxid-Präkursor enthält, ebenfalls direkt in eine Metalloxid-Schicht umgewandelt werden.

In manchen Ausführungsformen umfasst die Wärmebehandlung zunächst eine Wärmebehandlung bei 50 bis 350 °C, an die sich eine Wärmebehandlung bei 100-450 °C anschließt.

Im Allgemeinen kann die Ausbildung der ersten und/oder zweiten Metalloxid-Schicht über ein Zeitintervall von Sekunden bis Stunden verlaufen. Daher kann die Wärmebehandlung zur Ausbildung der ersten und/oder zweiten Metalloxid-Schicht über einen Zeitraum von Sekunden bis Stunden verlaufen. In manchen Ausführungsformen beträgt die Wärmebehandlung eine Stunde.

In bestimmten Ausführungsformen erfolgt die Ausbildung einer ersten und/oder zweiten festen Phase aus einer ersten und/oder zweiten flüssigen Phase, wobei durch eine Wärmebehandlung der ersten und/oder zweiten festen Phase eine erste und/oder zweite Metalloxid-Schicht aus der ersten und/oder zweiten festen Phase ausgebildet wird.

Ohne an eine bestimmte Theorie gebunden sein zu wollen, wird angenommen, dass es durch die Wärmebehandlung einer Metalloxid-Schicht, gegebenenfalls unterstützt durch elektromagnetische Strahlung, zur Umorganisation der Atome in der Metalloxid-Schicht kommt, so dass die Schicht halbleitende Eigenschaften, bzw. verbesserte halbleitende Eigenschaften aufweist. Entsprechend werden in verschiedenen Ausführungsformen die erste und/oder zweite flüssige Phase nicht nur bis zur Ausbildung einer ersten und oder zweiten festen Phase, sondern weiter bis zur Ausbildung der gewünschten Halbleitereigenschaften der ersten und/oder zweiten Metalloxid-Schicht einer Wärmebehandlung unterzogen.

Das Ausbilden der ersten und/oder zweiten Metalloxid-Schicht kann durch Wärmebehandlung und/oder durch elektromagnetische Strahlung erfolgen. In manchen Ausführungsformen kann eine Wärmebehandlung mit einem Temperaturprofil erfolgen, so dass zunächst mit einer geringen Temperatur begonnen wird, zum Beispiel 50 °C, und diese Temperatur im Folgenden bis zu einer bestimmten Temperatur, beispielsweise im Bereich 150-450 °C, gesteigert wird und dort für eine definierte Zeitspanne verbleibt. In manchen Ausführungsformen wird die Temperatur anschließend wieder auf Raumtemperatur gesenkt. Das Abkühlen kann dabei langsam oder schnell erfolgen. In manchen Ausführungsformen umfasst das Ausbilden der ersten und/oder zweiten Metalloxid-Schicht aus der ersten, bzw. zweiten flüssigen Phase eine Wärmebehandlung der ersten und/oder zweiten flüssigen Phase. Dadurch wird die erste und/oder zweite flüssige Phase in eine erste und/oder zweite feste Phase überführt, so dass im Verlauf der weiteren Wärmebehandlung eine erste und/oder zweite Metalloxid-Schicht ausgebildet wird.

Wenn die erste und/oder zweite flüssige Phase einen Metalloxid-Präkursor umfassen, dann können die Präkursoren durch die Wärmebehandlung zum korrespondierenden Metalloxid umgesetzt werden, so dass eine erste und/oder zweite Metalloxid-Schicht ausgebildet wird. In verschiedenen Ausführungsformen des Verfahrens werden die erste und/oder die zweite Metalloxid-Schicht durch eine Wärmebehandlung bei einer Temperatur von 100-450°C, bevorzugt bei 150-360 °C oder 150-350 °C ausgebildet.

Ebenfalls umfasst vom Begriff "Ausbilden einer Metalloxid-Schicht" sind Ausführungsformen, bei denen die erste und/oder die zweite flüssige Phase mit elektromagnetischer Strahlung bestrahlt werden, um die erste und/oder zweite Metalloxid-Schicht auszubilden. In verschiedenen Ausführungsformen werden die erste und/oder zweite flüssige Phase mit UV-, IR- und/oder VIS-Strahlung bestrahlt, um die erste und/oder zweite Metalloxid-Schicht auszubilden. In weiteren Ausführungsformen werden die erste und/oder die zweite flüssige Phase wärmebehandelt und vorher, nachher und/oder währenddessen mit elektromagnetischer Strahlung, insbesondere UV-, IR- und/oder VIS-Strahlung bestrahlt, um die erste und/oder zweite Metalloxid-Schicht auszubilden. Durch die Kombination einer thermischen und elektromagnetischen Behandlung kann die Ausbildung der ersten und/oder zweiten Metalloxid-Schicht verbessert werden. In bestimmten Ausführungsformen werden durch UV-Strahlung Bestandteile der ersten und/oder zweiten flüssigen Phase vor oder während der Wärmebehandlung quervernetzt.

Der Begriff "Ausbilden der ersten und/oder zweiten Metalloxid-Schicht" umfasst ebenfalls die Behandlung der ersten und/oder zweiten flüssigen Phase mit bestimmten Atmosphären. In manchen Fällen erfolgt das Ausbilden der ersten und/oder zweiten Metalloxid-Schicht unter Sauerstoff-haltiger Atmosphäre, insbesondere Luft. Zur Ausbildung der ersten und/oder zweiten Metalloxid-Schicht kann die erste und/oder die zweite flüssige Phase unter Sauerstoff-haltiger Atmosphäre, insbesondere mit Luft, mit Wärme behandelt werden. In weiteren Ausführungsformen des Verfahrens werden aus der ersten und/oder zweiten flüssigen Phase eine erste und/oder zweite feste Phase unter Sauerstoff-haltiger Atmosphäre, insbesondere Luft, ausgebildet und die erste und/oder zweite Metalloxid-Schicht unter Sauerstoff-haltiger Atmosphäre, insbesondere Luft, und Wärmebehandlung ausgebildet. In verschiedenen Ausführungsformen wird zunächst ein Vakuum angelegt, um aus der ersten und/oder zweiten flüssigen Phase eine feste Phase auszubilden und anschließend unter Luft, insbesondere durch Wärmebehandlung unter Sauerstoff-haltiger Atmosphäre, z. B. Luft, die erste und/oder zweite Metalloxid-Schicht ausgebildet. Ebenfalls kann das Ausbilden Verfahrensschritte umfassen, die zunächst unter Ausschluss von Luftfeuchtigkeit und/oder unter Schutzgas erfolgen und an die sich Schritte unter Sauerstoff-haltiger Atmosphäre, insbesondere Luft, anschließen.

Der Begriff "Sauerstoff-haltige Atmosphäre" im Sinne der vorliegenden Erfindung umfasst eine die Erdatmosphäre, insbesondere die bei Normalnull ("Luft"), sowie eine künstliche Atmosphäre mit mindestens 10 Vol.-% an molekularem Sauerstoff. In verschiedenen Ausführungsformen umfasst eine künstliche Atmosphäre mindestens 20, 30, 40, 50, 60, 70, 80 oder 90 Vol.-% an molekularem Sauerstoff. In manchen Ausführungsformen ist eine künstliche Atmosphäre eine Atmosphäre, die im Wesentlichen oder zu 100 Vol.-% aus molekularem Sauerstoff besteht. In manchen Ausführungsformen ist eine künstliche Atmosphäre eine Atmosphäre, die mit Wasserdampf angereichert ist.

Die Güte der nach dem erfindungsgemäßen Verfahren erzeugten ersten und/oder zweiten Metalloxid-Schicht kann weiterhin dadurch verbessert werden, dass das Ausbilden der ersten und/oder zweiten Metalloxid-Schicht eine vorgeschaltete, begleitende oder anschließende kombinierte Temperatur- und Gasbehandlung (mit $H_2O$, $H_2$ oder $O_2$), Plasmabehandlung (Ar-, $N_2$, $O_2$ oder $H_2$-Plasma), Laser-Behandlung (mit Wellenlängen im UV-, VIS- oder IR-Bereich) oder eine Ozon-Behandlung umfasst.

Die erste Metalloxid-Schicht weist eine Schichtdicke von ≤ 20 nm, bevorzugt von 0,5-20 nm, mehr bevorzugt von 0,5-10 nm, noch mehr bevorzugt von 2-5 nm auf. In verschiedenen Ausführungsformen weist die erste Metalloxid-Schicht eine Schichtdicke auf, die ausgewählt wird aus der Gruppe bestehend aus 0,5-5 nm, 1-5 nm, 2-6 nm, 2-4 nm, 0,5-4 nm, 1-4 nm, 0,5-3 nm, 1-3 nm, 0,5-6 nm und 1-6 nm. In manchen Ausführungsformen weist die erste Metalloxid-Schicht in verschiedenen Ausführungsformen eine Schichtdicke von 1 bis 20 nm, 1-15 nm, 1-10 nm, 1-9 nm, 1-8 nm, 1-7 nm, 3-6 nm, 3-5 nm, 2-4 nm, 2-3 nm oder 1-2 nm auf.

Dem Fachmann sind aus dem Stand der Technik Verfahren bekannt, mit denen er aus einer flüssigen Phase, die mindestens ein Metalloxid oder mindestens einen Metalloxid-Präkursor enthält, eine Metalloxid-Schicht ausbilden kann, die eine gewünschte Schichtdicke aufweist. Hierfür genügen beispielsweise einfache Verdünnungsreihen. Die erhaltenen Schichtdicken können etwa mittels Ellipsometrie (M. Schubert: Infrared Ellipsometry on semiconductor layer structures: Phonons, Plasmons, and Polaritons In: Springer Tracts in Modern Physics 209, Springer-Verlag, Berlin 2004) oder Rasterkraftmikroskopie (engl. AFM; G. Binnig, C. F. Quate, C. Gerber: Atomic force microscope. Physical Review Letters. 56, 1986, S. 930-933) bestimmt werden. Davon ausgehend bestimmt der Fachmann Parameter, wie zum Beispiel das Volumen, die Metalloxid- oder Metalloxid-Präkursor-Konzentration und gegebenenfalls die Partikeldichte in der flüssigen Phase, die es ihm erlauben, in dem erfindungsgemäßen Verfahren die gewünschte Metalloxid-Schichtdicke zu erzielen.

Generell enthalten die erste und zweite Metalloxid-Schicht mindestens ein Metalloxid, wobei das mindestens eine Metalloxid der ersten Metalloxid-Schicht von dem mindestens einen Metalloxid der zweiten Metalloxid-Schicht verschieden ist. In bestimmten Ausführungsformen bestehen die erste und/oder die zweite Metalloxid-Schicht aus jeweils einem Metalloxid. In verschiedenen Ausführungsformen können die erste und/oder die zweite Metalloxid-Schicht aus jeweils zwei Metalloxiden bestehen. In weiteren Ausführungsformen besteht die erste Metalloxid-Schicht im Wesentlichen aus einem Metalloxid und die zweite Metalloxid-Schicht enthält zwei oder mehr Metalloxide. In verschiedenen Ausführungsformen enthält die erste Metalloxid-Schicht zwei oder mehr Metalloxide und die zweite Metalloxid-Schicht besteht aus einem Metalloxid.

In weiteren Ausführungsformen des Verfahrens umfasst die zweite Metalloxid-Schicht mindesten ein Metalloxid, das nicht in der ersten Metalloxid-Schicht enthalten ist. Das bedeutet, dass wenn beide Metalloxid-Schicht jeweils aus nur einem Metalloxid bestehen, dass dann die beiden Metalloxide unterschiedlich sind. Wenn die erste Metalloxid-Schicht aus zwei Metalloxiden besteht und die zweite Metalloxid-Schicht aus einem Metalloxid besteht, dann ist das Metalloxid der zweiten Metalloxid-Schicht von den Metalloxiden der ersten Metalloxid-Schicht verschieden. Wenn beide Metalloxid-Schichten mindestens aus zwei Metalloxiden bestehen, dann besitzt die zweite Metalloxid-Schicht mindestens ein Metalloxid, das nicht in der ersten Metalloxid-Schicht enthalten ist.

In weiteren Ausführungsformen des Verfahrens umfasst die zweite Metalloxid-Schicht Siliziumoxid.

In einigen Ausführungsformen des Verfahrens besteht die erste Metalloxid-Schicht im Wesentlichen aus Indi-umoxid ($In_2O_3$) oder Indium-Gallium-Oxid. In verschiedenen Ausführungsformen besteht die erste Metalloxid-Schicht aus Indium-Gallium-Oxid, wobei das Gewichtsverhältnis Indium:Gallium von 70:30, 80:20, 90:10, 95:5, 99,0:1,0 bis 99,9:0,1 beträgt. In einer solchen Konfiguration kann beispielsweise die zweite Metalloxid-Schicht im Wesentlichen oder ausschließlich aus Galliumoxid ($Ga_2O_3$) bestehen.

In verschiedenen Ausführungsformen kann die erste Metalloxid-Schicht eine reine Indiumoxid-, Galliumoxid-, Zinnoxid- und/oder Zinkoxid-Schicht sein, d.h. bei Nichtberücksichtigung etwaiger Carben-, Alkoxid-, Oxoalkoxid- oder Halogen-Anteile im Wesentlichen aus oxidisch vorliegenden Indium-, Gallium-, Zinn- und/oder Zinkatomen bzw. -ionen bestehen. In einigen Ausführungsformen kann die erste Metalloxid-Schicht anteilig noch weitere Metalle, die selbst in elementarer oder oxidischer Form vorliegen können, aufweisen.

In bestimmten Ausführungsformen des Verfahrens besteht die zweite Metalloxid-Schicht im Wesentlichen aus ZnO, $Ga_2O_3$, $HfO_2$, $SiO_2$, Silizium-Gallium-Oxid oder Silizium-Hafnium-Oxid.

In weiteren Ausführungsformen besteht die erste Metalloxid-Schicht aus Indium-, Gallium-, Zink- und/oder Zinnoxid. In bestimmten Ausführungsformen besteht die erste Metalloxid-Schicht aus reinem Indiumoxid ($In_2O_3$) oder Indium-Gallium-Oxid.

Die zweite Schicht kann in verschiedenen Ausführungsformen Lithiumoxid, Natriumoxid, Kaliumoxid, Rubidiumoxid, Cäsiumoxid, Berylliumoxid, Magnesiumoxid, Calciumoxid, Strontiumoxid, Bariumoxid, Galliumoxid, Zinkoxid, Zinnoxid, Hafniumoxid, Siliziumoxid, Aluminiumoxid und/oder Titanoxid umfassen. In weiteren Ausführungsformen des Verfahrens besteht die zweite Metalloxid-Schicht im Wesentlichen aus $Li_2O$, $Na_2O$, $K_2O$, $Ru_2O$, $Cs_2O$, BeO, MgO, CaO, SrO, BaO, $Ga_2O_3$ ZnO, $SnO_2$, $HfO_2$, $SiO_2$, $Al_2O_3$ oder $TiO_2$.

In bestimmten Ausführungsformen besteht die erste Metalloxid-Schicht im Wesentlichen aus reinem Indiumoxid ($In_2O_3$) und die zweite Metalloxid-Schicht im Wesentlichen aus $Li_2O$, $Na_2O$, $K_2O$, $Ru_2O$, $Cs_2O$, BeO, MgO, CaO, SrO, BaO, $Ga_2O_3$, ZnO, $SnO_2$, $HfO_2$, $SiO_2$, $Al_2O_3$ oder $TiO_2$.

In einigen Ausführungsformen besteht die erste Metalloxid-Schicht im Wesentlichen aus reinem Indium-Gallium-Oxid und die zweite Metalloxid-Schicht im Wesentlichen aus $Li_2O$, $Na_2O$, $K_2O$, $Ru_2O$, $Cs_2O$, BeO, MgO, CaO, SrO, BaO, $Ga_2O_3$, ZnO, $SnO_2$, $HfO_2$, $SiO_2$, $Al_2O_3$ oder $TiO_2$.

Die Reihenfolge, in der aus der ersten und der zweiten flüssigen Phase die erste und die zweite Metalloxid-Schicht ausgebildet werden, kann optional gewählt werden, je nachdem welche Gestalt für das resultierende Halbleiterelement gewünscht wird.

Unter dem Begriff "Halbleiterelement" wird im Sinne der vorliegenden Erfindung ein Laminat verstanden, welches das Halbleiterlaminat der vorliegenden Erfindung sowie ein Substrat und eine Gate-Elektrode umfasst. Dabei schließt sich an die die Dielektrikum-Schicht des Halbleiterlaminats der vorliegenden Erfindung die Gate-Elektrode an. Die Gate-Elektrode liegt somit auf der der ersten Metalloxid-Schicht gegenüberliegenden Seite der Dielektrikum-Schicht. Je nachdem, ob in dem Halbleiterelement die Gate-Elektrode im Verhältnis zum Halbleiterlaminat dem Substrat zu- oder abgewandt ist, wird von einer Bottom-Gate oder Top-Gate Konfiguration gesprochen. Ebenfalls kann das Halbleiterelement Elektrodenkontakte umfassen, die an der ersten und/oder zweiten Metalloxid-Schicht anliegen. An den Elektrodenkontakten können Quell- und Senk-Elektroden (Source und Drain) angeschlossen sein. Verschiedene nicht einschränkende Ausführungsformen des beanspruchten Halbleiterlaminats in einem solchen Halbleiterelement werden in Figur 2 dargestellt.

In diversen Ausführungsformen des Verfahrens umfasst somit das Ausbilden der ersten Metalloxid-Schicht das Aufbringen der ersten flüssigen Phase auf die Dielektrikum-Schicht und das Abscheiden des mindestens einen Metalloxids oder des mindestens einen Metalloxid-Präkursors der ersten flüssigen Phase auf der Dielektrikum-Schicht, um die erste Metalloxid-Schicht auf der Dielektrikum-Schicht auszubilden. Bei diesen Ausführungsformen umfasst das Ausbilden der zweiten Metalloxid-Schicht das Aufbringen der zweiten flüssigen Phase auf die erste Metalloxid-Schicht, und das Abscheiden des mindestens einen Metalloxids oder des mindestens einen Metalloxid-Präkursors der zweiten flüssigen Phase auf der ersten Metalloxid-Schicht, um die zweite Metalloxid-Schicht auf der ersten Metalloxid-Schicht auszubilden. Im bestimmten Ausführungsformen befindet sich die Dielektrikum-Schicht auf einem Substrat. Dann ergibt sich ein Halbleiterelement der Bottom-Gate Konfiguration.

Unter "Abscheiden" wird im Sinne der vorliegenden Erfindung verstanden, dass das mindestens ein Metalloxid oder der mindestens ein Metalloxid-Präkursor aus einer ersten und/oder zweiten flüssigen Phase in Form einer festen Phase auf einer Oberfläche abgelagert wird. Das schließt beispielsweise Adsorption, Präzipitation, etc. ein. Somit umfasst der Begriff Abscheiden beispielsweise das Verdunsten der flüssigen Phase und das Verdampfen der flüssigen Phase, um so aus einer ersten und/oder zweiten flüssigen Phase eine erste und/oder zweite feste Phase auszubilden. Das Verdampfen der flüssigen Phase kann zum Beispiel durch die hierin beschriebene Wärmebehandlung und/oder Anlegen eines Vakuums oder Gas-Stroms, insbesondere eines Stroms mit Sauerstoff-haltiger Atmosphäre oder Luft-Stroms, erfolgen. Ferner umfasst der Begriff Abscheiden die elektrolytische Anreicherung des mindestens einen Metalloxids oder des mindestens einen Metalloxid-Präkursors an einer Oberfläche. Ebenfalls kann das Abscheiden durch die hierin beschriebene Wärmebehandlung und/oder durch elektromagnetische Strahlung, insbesondere UV-, IR- und VIS-Strahlung erfolgen. In einigen Ausführungsformen ist die erste und/oder zweite feste Phase eine erste und/oder zweite Metalloxid-Schicht. In anderen Ausführungsformen umfasst das Ausbilden der ersten und/oder zweiten Metalloxid-Schicht aus der ersten und/oder zweiten flüssigen Phase das Ausbilden der ersten und/oder zweiten Metalloxid-Schicht aus der ersten und/oder zweiten festen Phase.

In weiteren Ausführungsformen des vorliegenden Verfahrens umfasst das Ausbilden der zweiten Metalloxid-Schicht das Aufbringen der zweiten flüssigen Phase auf einem Substrat, und das Abscheiden des mindestens einen Metalloxids oder des mindestens einen Metalloxid-Präkursors der zweiten flüssigen Phase auf dem Substrat, um die zweite Metalloxid-Schicht auf dem Substrat auszubilden. In diesen Ausführungsformen umfasst das Ausbilden der ersten Metalloxid-Schicht das Aufbringen der ersten flüssigen Phase auf die zweite Metalloxid-Schicht, und das Abscheiden des mindestens einen Metalloxids oder der mindestens einen Metalloxid-Präkursors der ersten flüssigen Phase auf der zweiten Metalloxidschicht, um die erste Metalloxid-Schicht auf der zweiten Metalloxid-Schicht auszubilden, und das Aufbringen der Dielektrikum-Schicht auf die erste Metalloxid-Schicht. Im bestimmten Ausführungsformen wird anschließend eine Gate-Elektrode auf der Dielektrikum-Schicht ausgebildet. Dann ergibt sich ein Halbleiterelement der Top-Gate Konfiguration.

Die Erfinder der vorliegenden Erfindung haben zudem überraschend herausgefunden, dass sich die zweite Metalloxid Schicht nicht nur zur Dotierung der ersten Metalloxid-Schicht eignet, sondern auch als Passivierungsschicht für ein Halbleiterelement. Beispielsweise im Falle einer Konfiguration eines Halbleiterelementes, bei der von der ersten Metalloxid-Schicht aus gesehen die Dielektrikum-Schicht dem Substrat zugewandt ist, kann die zweite Metalloxid-Schicht als Passivierungsschicht dienen, so dass sie das Halbleiterelement abschließt und vor atmosphärischen Einflüssen schützt.

So kann in bestimmten Ausführungsformen des Verfahrens die zweite Metalloxid-Schicht im Wesentlichen aus Silizium-Hafnium-Oxid bestehen. Hier kann beispielsweise das Gewichtsverhältnis Silizium:Hafnium von 70:30 bis 99,9:0,1 betragen.

In einigen Ausführungsformen des Verfahrens umfasst der Begriff "Aufbringen einer ersten und/oder zweiten flüssige Phase" ein Verfahren, das ausgewählt wird aus der Gruppe bestehend aus Druckverfahren, Sprühverfahren, Rotationsbeschichtungsverfahren, Tauchverfahren und Slot-Die Coating. Dabei umfasst der Begriff " Druckverfahren" Verfahren, die ausgewählt werden aus der Gruppe bestehend aus, aber nicht eingeschränkt sind auf Flexo/Gravur-Druck, Tintenstrahl-Druck, Offset-Druck, digitalem Offset-Druck und Siebdruck. Nicht umfasst von der vorliegenden Erfindung sind Verfahren, die auf einer Abscheidung der Metalloxid-Schicht aus der Gasphase basieren. In verschiedenen Ausführungsformen umfasst das Aufbringen der ersten und/oder zweiten flüssigen Phase das Aufbringen unter Ausschluss von Sauerstoff-haltiger Atmosphäre, Luft und/oder bei reduzierter Luftfeuchtigkeit. In weiteren Ausführungsformen werden die erste und/oder zweite flüssige Phase unter Schutzgas aufgebracht.

In verschiedenen Ausführungsformen des Verfahrens umfassen die erste und/oder die zweite flüssige Phase mindestens ein organisches Lösungsmittel. Dabei können die erste und/oder zweite flüssige Phase sowohl ein Lösungsmittel oder ein Gemisch verschiedener Lösungsmittel umfassen. Geeignete Lösungsmittel werden ausgewählt aus aprotischen und schwach protischen Lösungsmitteln, insbesondere Lösungsmitteln ausgewählt aus der Gruppe der aprotischen unpolaren Lösungsmittel. In verschiedenen Ausführungsformen sind die organischen Lösungsmittel im Wesentlichen wasserfrei. Vorzugsweise sind die organischen Lösungsmittel wasserfrei. Dies kann in bestimmten Ausführungsformen, zum Beispiel wenn Metalloxid-Präkursoren der Klasse metallorganischer Verbindungen verwendet werden, das Aufbringen ersten und/oder zweiten flüssigen Phase und/oder das Ausbilden der ersten und/oder zweiten Metalloxid-Schicht erleichtern oder verbessern.

Dementsprechend können geeignete Lösungsmittel ausgewählt werden aus der Gruppe bestehend aus substituierten und/oder nicht-substituierten Alkanen, substituierten und/oder nicht-substituierten Alkenen, substituierten und/oder nicht-substituierten Alkinen, substituierten und/oder nicht-substituierten Aromaten, Aromaten mit aliphatischen oder aromatischen Substituenten, halogenierten Kohlenwasserstoffen, Tetramethylsilan, Ethern, beispielsweise aromatischen Ethern und substituierten Ethern, Estern oder Säureanhydriden, Ketonen, tertiären Aminen, Nitromethan, DMF (Dimethylformamid), DMSO (Dimethylsulfoxid), Propylencarbonat, Alkoholen, primären und sekundären Aminen und Formamid. Besonders bevorzugte Lösungsmittel sind Alkohole sowie Toluol, Ethanol, 1-Methoxy-2-propanol (PGME), 1-Methoxypropan-2-yl-acetat (PGMEA), Xylol, Anisol, Mesitylen, n-Hexan, n-Heptan, Tris-(3,6-dioxaheptyl)-amin (TDA), 2-Aminomethyltetrahydrofuran, Phenetol, 4-Methylanisol, 3-Methylanisol, Methylbenzoat, N-Methyl-2-pyrrolidon (NMP), Tetralin, Ethylbenzoat und Diethylether.

Ganz besonders bevorzugte Lösemittel sind Isopropanol, Ethanol, PGME, PGMEA, Tetrahydrofurfurylalkohol, tert-Butanol und Toluol sowie ihre Gemische.

In bevorzugten Ausführungsformen weisen die erste und/oder zweite flüssige Phase eine Viskosität von 1 mPa•s bis 10 Pa•s, insbesondere 1 mPa•s bis 100 mPa•s bestimmt nach DIN 53019 Teil 1 bis 2 und gemessen bei Zimmertemperatur auf. Solche Viskositäten können sich besonders zum Drucken der entsprechenden flüssigen Phase eignen.

In manchen Ausführungsformen wird die Viskosität der ersten und/oder zweiten flüssigen Phase vor der Verwendung bestimmt. Daher kann es sein, dass das beanspruchte Verfahren ferner die Einstellung der Viskosität der ersten und/oder zweiten flüssigen Phase auf die gewünschte Viskosität umfasst.

Zum Einstellen der gewünschten Viskosität können der ersten und/oder zweiten flüssigen Phase vor dem Auftragen Verdickungsmittel zu gegeben werden. Geeignete Verdickungsmittel können ausgewählt werden aus der Gruppe bestehend aus Cellulosederivaten, $SiO_2$, das unter dem Handelsnamen AEROSIL® erhältlich ist, Polymethylmethacrylatverdickern, Polyvinylalkohol, Urethanverdickem und Polyacrylatverdickern.

In diversen Ausführungsformen des Verfahrens umfassen die erste und/oder die zweite flüssige Phase eine wässrige Phase. Somit kann die erste und/oder zweite flüssige Phase eine wässrige Phase oder ein

Zwei- oder Mehr-Phasensystem umfassen, wobei eine Phase eine wässrige Phase ist. Die mindestens eine weitere Phase kann ein organisches Lösungsmittel umfassen, wie es hierin beschrieben ist. In verschieden Ausführungsformen sind die erste und/oder zweite flüssige Phase eine wässrige Lösung, Dispersion oder Emulsion.

Als mögliche Präkursoren für die Synthese Metalloxid-haltiger Schichten sind eine Vielzahl von Stoffen und Verbindungsklassen geeignet. Wie oben beschrieben, umfasst die Gruppe der Metalloxid-Präkursoren elementare Metalle, Metallsalze, metallorganische Verbindungen, insbesondere Metall-Alkoxide und Metall-Oxoalkoxide.

Der Begriff "metallorganische Verbindung" im Sinne dieser Erfindung umfasst jegliche Verbindung, die mindestens ein Metall und mindestens eine organische Verbindung umfasst und die in ein Metalloxid überführt werden kann. Metallorganische Verbindungen für die Ausbildung der ersten Metalloxid-Schicht umfassen mindestens ein Metall, das ausgewählt wird aus der Gruppe bestehend aus Indium, Gallium, Zink und Zinn. Metallorganische Verbindung für die Ausbildung der zweiten Metalloxid-Schicht umfassen mindestens ein Metall, das ausgewählt wird aus der Gruppe bestehend aus Lithium, Natrium, Kalium, Rubidium, Cäsium, Beryllium, Magnesium, Calcium, Strontium, Barium, Gallium, Zink, Zinn, Hafnium, Silizium, Aluminium und Titan.

Die mindestens eine organische Verbindung der metallorganischen Verbindung kann, unabhängig davon, ob der Präkursor für die Ausbildung der ersten und/oder der zweiten Metalloxid-Schicht dient, mindestens einen Rest umfassen, der aus der Gruppe bestehend aus Wasserstoff, substituiertem oder nicht-substituiertem $C_{1-50}$ Alkyl, substituiertem oder nicht-substituiertem $C_{2-50}$ Alkenyl, substituiertem oder nicht-substituiertem $C_{2-50}$ Alkinyl, substituiertem oder nicht-substituiertem $C_{1-50}$ Alkoxy, substituiertem oder nicht-substituiertem $C_{5-50}$ Aryl, substituiertem oder nicht-substituiertem $C_{4-50}$ Heteroaryl, substituiertem oder nicht-substituiertem $C_{1-50}$ Oxoalkoxy, substituiertem oder nicht-substituiertem $C_{6-50}$ Alkylaryl, substituiertem oder nicht-substituiertem $C_{6-50}$ Aralkyl, substituiertem oder nicht-substituiertem $C_{5-50}$ Alkylheteroaryl, substituiertem oder nicht-substituiertem $C_{3-50}$ Cycloalkyl und substituiertem oder nicht-substituiertem $C_{2-50}$ Heterocycloalkyl. Wenn substituiert, werden die Substituenten der metallorganischen Verbindungen ausgewählt aus der Gruppe bestehend aus $C_{1-50}$ Alkyl, $C_{2-50}$ Alkenyl, $C_{2-50}$ Alkinyl, $C_{1-50}$ Alkoxy, $C_{5-50}$ Aryl, $C_{5-50}$ Heteroaryl, $C_{1-50}$ Oxoalkoxy, $C_{6-50}$ Alkylaryl, $C_{6-50}$ Aralkyl, $C_{4-50}$ Alkylheteroaryl, $C_{3-50}$ Cycloalkyl und $C_{2-50}$ Heterocycloalkyl. In manchen Ausführungsformen umfassen die metallorganischen Verbindungen mindestens ein Halogen, das ausgewählt wird aus der Gruppe bestehend aus F, Cl, Br und I.

Geeignete Metalloxid-Präkursoren sind im Stand der Technik gut beschrieben und somit dem Fachmann ausreichend bekannt. Zum Beispiel offenbaren WO2010/094583 A1 und WO2011/020792 A1 geeignete Metalloxid-Präkursoren. Die Offenbarung dieser Dokumente wird hiermit in ihrer Gesamtheit der Offenbarung dieser Patentanmeldung mit aufgenommen. Insbesondere offenbaren die beiden Dokumente geeignete Metall-Alkoxid und Metall-Oxoalkoxid Präkursoren für die Herstellung von Metalloxid-Schichten sowie Verfahren zur Herstellung solcher Schichten.

Unter einem Metall-Alkoxid ist dabei eine Verbindung bestehend aus mindestens einem Metallatom, mindestens einem Alkoxy-Rest der Formel -OR (R = organischer Rest) und ggf. einem oder mehreren organischen Resten -R, einem oder mehreren Halogenresten und/oder einem oder mehreren Resten -OH oder -OROH zu verstehen.

Gegenüber Metall-Alkoxiden weisen Metall-Oxoalkoxide noch mindestens einen weiteren, direkt an mindestens ein Metallatom gebundenen oder verbrückenden Sauerstoff-Rest (Oxo-Rest) auf.

Bei dem Metall-Alkoxid oder Metall-Oxoalkoxid handelt es sich in verschiedenen Ausführungsformen um ein Alkoxid/Oxoalkoxid mit mindestens einer $C_1$- bis $C_{15}$-Alkoxy- oder -Oxyalkylalkoxy-Gruppe, besonders bevorzugt mindestens einer $C_1$ - bis $C_{10}$-Alkoxy- oder -Oxyalkylalkoxy-Gruppe. Ganz besonders bevorzugt ist das Metall-Alkoxid und -Oxoalkoxid der generischen Formel $M(OR)_x$, in der R eine $C_1$- bis $C_{15}$-Alkyl- oder -Alkyloxyalkyl-Gruppe, noch weiter bevorzugt eine $C_1$- bis $C_{10}$-Alkyl- oder - Alkyloxyalkyl-Gruppe darstellt. Dabei ist x eine ganze Zahl, die der Oxidationsstufe des Metalls (M) entspricht. In einigen Ausführungsformen entspricht die Oxidationsstufe des Metalls in dem Metall-Präkursor der Oxidationsstufe, in der das Metall später als Metalloxid in der ersten und/oder zweiten Metalloxid-Schicht vorliegt. Besonders bevorzugt sind die Metall-Alkoxide $M(OCH_3)_x$, $M(OCH_2CH_3)_x$, $M(OCH_2CH_2OCH_3)_x$, $M(OCH(CH_3)_2)_x$ oder $M(O(CH_3)_3)_x$. Noch weiter bevorzugt wird $M(OCH(CH_3)_2)_x$ (Metallisopropoxid) eingesetzt. In dem Fall, in dem ein solcher Metalloxid-Präkursor zur Ausbildung der ersten Metalloxid-Schicht dient, wird M ausgewählt aus der Gruppe bestehend aus Indium, Gallium, Zink und Zinn. In dem Fall, in dem ein solcher Metalloxid-Präkursor zur Ausbildung der zweiten Metalloxid-Schicht dient, wird M ausgewählt aus der Gruppe bestehend aus Gallium, Zink, Zinn, Hafnium, Silizium, Aluminium, Titan, Alkalimetallen und Erdalkalimetallen.

In verschiedenen Ausführungsformen umfasst die erste Metalloxid-Schicht mindestens Indiumoxid und wird aus mindestens einem Indium-Präkursor, insbesondere einem Indium-Alkoxid-Präkursor oder Indium-Oxoalkoxid-Präkursor ausgebildet. Das Indium-Alkoxid oder Indium-Oxoalkoxid ist bevorzugt ein Indium(III)-Alkoxid/-Oxoalkoxid. Weiter bevorzugt handelt es sich bei dem Indium(III)-Alkoxid/- Oxoalkoxid um ein Alkoxid/Oxoalkoxid mit mindestens einer $C_1$- bis $C_{15}$-Alkoxy- oder -Oxyalkylalkoxy-Gruppe, besonders bevorzugt mindestens einer $C_1$- bis $C_{10}$-Alkoxy- oder -Oxyalkylalkoxy-Gruppe. Ganz besonders bevorzugt ist das Indium(III)-Alkoxid/-Oxoalkoxid ein Alkoxid der generischen Formel $In(OR)_3$, in der R eine $C_1$- bis $C_{15}$-Alkyl- oder -Alkyloxyalkyl-Gruppe, noch weiter bevorzugt eine $C_1$- bis $C_{10}$-Alkyl- oder -Alkyloxyalkyl-Gruppe darstellt. Besonders bevorzugt ist dieses Indium(III)-Alkoxid, bzw. -Oxoalkoxid $In(OCH_3)_3$,

In(OCH$_2$CH$_3$)$_3$, In(OCH$_2$CH$_2$OCH$_3$)$_3$, In(OCH(CH$_3$)$_2$)$_3$ oder In(O(CH$_3$)$_3$)$_3$. Noch bevorzugter wird In(OCH(CH$_3$)$_2$)$_3$ (Indiumisopropoxid) eingesetzt.

Das Indium-Alkoxid/-Oxoalkoxid liegt bevorzugt in Anteilen von 1 bis 15 Gew.-%, besonders bevorzugt 2 bis 10 Gew.-%, ganz besonders bevorzugt 2,5 bis 7,5 Gew.-% bezogen auf die Gesamtmasse der ersten flüssigen Phase vor.

Zur Erzeugung reiner Indium-, Gallium-, Zinn- und/oder Zinkoxid-Schichten werden bei dem erfindungsgemäßen Verfahren nur Indium-, Gallium-, Zinn-und/oder Zink-haltige Präkursoren, bevorzugt nur Oxoalkoxide und Alkoxide, eingesetzt.

In manchen Ausführungsformen können die erste und/oder zweite flüssige Phase neben Metalloxid-Präkursoren auch Metalle in der Oxidationsstufe 0 umfassen, um Metalloxid-Schichten auszubilden, die neben dem Metalloxid weitere Metalle in neutraler Form enthalten.

In einigen Ausführungsformen des vorliegenden Verfahrens stammt der mindestens eine Metalloxid-Präkusor der ersten und/oder zweiten flüssigen Phase aus der Klasse der Metall-Alkoxide und/oder Metall-Oxoalkoxide.

Das vorliegende erfindungsgemäße Verfahren liefert bei der Herstellung der ersten und/oder der zweiten Metalloxid-Schicht besonders gute Ergebnisse, wenn als einziger Metalloxid-Präkursor das Metall-Alkoxid oder Metall-Oxoalkoxid eingesetzt wird.

In bestimmten Ausführungsformen kann ein Metall-Oxoalkoxid als Metalloxid-Präkursor verwendet werden, das die generische Formel M$_x$O$_y$(OR)$_z$[O(R'O)$_c$H]$_a$X$_b$[R"OH]$_d$ mit M = In, Ga, Sn und/oder Zn für die erste Metalloxid-Schicht und M = Ga, Sn, Zn, Al, Ti, Li, Na, K, Rb, Cs, Be, Mg, Ca, Sr, Ba, Hf und/oder Si für die zweite Metalloxid-Schicht, x = 3 - 25, y = 1 - 10, z = 3 - 50, a = 0 - 25, b = 0 - 20, c = 0 - 1, d = 0 - 25, R, R', R" = organischer Rest, und X = F, Cl, Br, I, besitzt. In einer solchen und anderen Ausführungsform kann die erste und/oder zweite flüssige Phase ein organisches Lösungsmittel umfassen, insbesondere ein im Wesentlichen wasserfreies, ganz besonders bevorzugt ein wasserfreies organisches Lösungsmittel.

In verschiedenen Ausführungsformen kann ein Metall-Oxoalkoxid als Metalloxid-Präkursor verwendet werden, das die generische Formel M$_x$O$_y$(OR)$_z$ mit M = In, Ga, Sn und/oder Zn für die erste Metalloxid-Schicht und M = Ga, Sn, Zn, Al, Ti, Li, Na, K, Rb, Cs, Be, Mg, Ca, Sr, Ba, Hf und/oder Si für die zweite Metalloxid-Schicht, x = 3 - 20, y = 1 - 8, z = 1 - 25, OR = C1 -C15-Alkoxy-, -Oxyalkylalkoxy, -Aryloxy- oder -Oxyarylalkoxy-Gruppe, wobei besonders bevorzugt ein solches der generischen Formel M$_x$O$_y$(OR)$_z$ mit M = In, Ga, Sn und/oder Zn für die erste Metalloxid-Schicht und M = Ga, Sn, Zn, Al, Ti, Li, Na, K, Rb, Cs, Be, Mg, Ca, Sr, Ba, Hf und/oder Si für die zweite Metalloxid-Schicht, x = 3 - 15, y = 1 - 5, z = 10 - 20, OR = - OCH$_3$, -OCH$_2$CH$_3$, -OCH$_2$CH$_2$OCH$_3$, -OCH(CH$_3$)$_2$ oder -O(CH$_3$)$_3$ eingesetzt wird.

In weiteren Ausführungsformen kann ein Metall-Oxoalkoxid als Metalloxid-Präkursor verwendet werden, das die Formel [In$_5$($\mu_5$-O)($\mu_3$-O $^i$Pr)$_4$($\mu_2$-O$^i$Pr)$_4$(O$^i$Pr)$_5$] besitzt. Ein solcher Metall-Präkursor kann insbesondere für die Ausbildung der ersten Metalloxid-Schicht verwendet werden.

In einigen Ausführungsformen kann ein Metall-Oxoalkoxid als Metalloxid-Präkursor verwendet werden, das die Formel [Sn$_3$O(O$^i$Bu)$_{10}$($^i$BuOH)$_2$] und/oder [Sn$_6$O$_4$(OR)$_4$] besitzt. Solche Metall-Präkursoren können für die Ausbildung der ersten und/oder zweiten Metalloxid-Schicht verwendet werden.

Ebenfalls können Metallsalze als Metalloxid-Präkursoren für die Herstellung von Metalloxid-Schichten dienen. In manchen Ausführungsformen umfasst die erste flüssige Phase mindestens ein Metallsalz, das nicht abschließend ausgewählt wird aus der Gruppe bestehend aus Halogeniden, Nitraten, Sulfaten, Phosphaten, Carbonaten, Acetaten und Oxalaten von mindestens einem Metall, das ausgewählt wird aus der Gruppe bestehend aus Indium, Gallium, Zink, und Zinn. In weiteren Ausführungsformen umfasst die zweite flüssige Phase mindestens ein Metallsalz, das nicht abschließend ausgewählt wird aus der Gruppe bestehend aus Halogeniden, Nitraten, Sulfaten, Phosphaten, Carbonaten, Acetaten und Oxalaten von mindestens einem Metall, das ausgewählt wird aus der Gruppe bestehend aus Gallium, Zink, Zinn, Hafnium, Silizium, Aluminium, Titan, Alkalimetallen und Erdalkalimetallen. Solche Metallsalze können beispielsweise in wässriger Phase verwendet werden. Aus bestimmten Metallsalz-haltigen Phasen können durch Wärmebehandlung und/oder elektromagnetische Strahlung, insbesondere UV-Strahlung, Metalloxid-Schichten ausgebildet werden.

In manchen Fällen, wie zum Beispiel für Metallhalogenide, kann das Metallsalz über einen Zwischenschritt in das Metalloxid überführt werden. Zum Beispiel kann ein Metallhalogenid zunächst in eine metallorganische Verbindung überführt werden, die dann oxidiert wird, um die Metalloxid-Schicht auszubilden. In manchen Ausführungsformen umfassen dafür die erste und/oder die zweite flüssige Phase ein oder mehrere Metallsalze, wobei die erste und/oder zweite flüssige Phase ein organisches Lösungsmittel umfassen. Die so intermediär gebildeten metallorganischen Verbindungen umfassen die hierin beschriebenen Metall-Alkoxy und Metall-Oxoalkoxy Verbindungen. Solche Verfahren sind in dem Stand der Technik gut bekannt.

Beispielsweise offenbaren Kim et al. (J. Am. Chem. Soc. (2008) 130: 12580-12581 und supplemental informations) die Ausbildung von Indiumoxid ausgehend von Indiumsalzen. So werden Bauteile beschrieben, bei deren Herstellung eine Precursorlösung aus InCl$_3$ sowie der Base Monoethanolamin (MEA) gelöst in Methoxyethanol eingesetzt wird. Nach Aufschleudern (Spin-coating) der Lösung wird die entsprechende Indiumoxid-Schicht durch eine thermische Behandlung bei 400 °C ausgebildet.

In einigen Ausführungsformen ist der mindestens eine Metalloxid-Präkursor der ersten und/oder der zweiten flüssigen Phase ein elementares Metall. Hier kann das elementare Metall in Form von Nanopartikeln in der Flüssigkeit vorliegen und mittels Behandlung mit Sauerstoff-haltiger Atmosphäre, z. B. Luft, insbesondere mit reinem Sauerstoff in das Metalloxid umgewandelt werden. In einigen Ausführungsformen wird die Ausbildung der Metalloxid-Schicht durch Wärmebehandlung und/oder elektromagnetische Strahlung, insbesondere UV-, IR- und/oder VIS-Strahlung unterstützt. Somit enthält in einigen Ausführungsformen die erste flüssige Phase mindesten einen Metalloxid-Präkursor der Klasse der elementaren Metalle, wobei das Metall aus der Gruppe bestehend aus Indium, Gallium, Zink und Zinn ausgewählt wird. Die zweite flüssige Phase enthält in einigen Ausführungsformen mindestens einen Metalloxid-Präkursor der Klasse der elementaren Metalle, wobei das Metall aus der Gruppe bestehend aus Gallium, Zink, Zinn, Hafnium, Silizium, Aluminium, Titan, Alkalimetallen und Erdalkalimetallen ausgewählt wird.

In weiteren Ausführungsformen werden die erste und/oder zweite Metalloxid-Schicht aus einer ersten und/oder zweiten flüssigen Phase ausgebildet, wobei die erste und/oder zweite Flüssigkeit mindestens einen Metalloxid-Präkursor umfassen, der eine metallorganische Verbindung ist. Dabei wird für die erste flüssige Phase das Metall der mindestens einen Metalloxid-Verbindung ausgewählt aus der Gruppe bestehend aus Indium, Gallium, Zink und/oder Zinn. Für die zweite flüssige Phase wird das Metall der mindestens eine Metalloxid-Verbindungen ausgewählt aus der Gruppe bestehend aus Gallium, Zink, Zinn, Hafnium, Silizium, Aluminium, Titan, Alkalimetallen und/oder Erdalkalimetallen. In bestimmten Ausführungsformen werden die so erhaltenen ersten und/oder zweiten flüssigen Phasen einer Wärmebehandlung und/oder elektromagnetischen Strahlung unterworfen, um die erste und/oder zweite flüssige Phase auszubilden.

Die Ausbildung der der ersten und/oder zweiten Metalloxid-Schicht kann ebenfalls durch Sol-Gel-Prozesse bewerkstelligt werden, die im Stand der Technik gut bekannt sind.

JP 06-136162 A (Fujimori Kogyo K.K.) beschreibt ein Verfahren zur Herstellung eines Metalloxid-Filmes aus Lösung auf einem Substrat, bei dem eine Metallalkoxid-Lösung, insbesondere eine IndiumIsopropoxid-Lösung, zu einem Metall-Oxid-Gel umgesetzt, auf ein Substrat aufgetragen, getrocknet und mit Wärme behandelt wird, wobei vor, während oder nach dem Trocknungs- und Wärmebehandlungsschritt die Lösung mit UV-Strahlung bestrahlt wird.

Auch JP 09-157855 A (Kansai Shin Gijutsu Kenkyusho K.K.) beschreibt die Herstellung von Metalloxid-Filmen aus Metall-Alkoxid-Lösungen über eine Metall-Oxid-Sol-Zwischenstufe, die auf das Substrat aufgebracht und durch UV Strahlung in das jeweilige Metalloxid umgewandelt wird. Bei dem resultierenden Metalloxid kann es sich um Indiumoxid handeln.

CN 1280960 A beschreibt die Herstellung einer Indium-Zinn-Oxid-Schicht aus Lösung über ein Sol-Gel-Verfahren, bei dem ein Gemisch von Metall-Alkoxiden in einem Lösemittel gelöst, hydrolysiert und dann zur Beschichtung eines Substrates mit nachfolgender Trocknung und Härtung eingesetzt wird. Entsprechend kann in manchen Ausführungsformen der vorliegenden Erfindung die erste und/oder zweite flüssige Phase mindestens ein Metall-Alkoxid und Wasser umfassen, insbesondere eine signifikante Menge Wasser oder eine flüssige Phase aus im Wesentlichen Wasser. In Sol-Gel-Verfahren werden die erste und/oder zweite flüssige Phase durch Hydrolyse und nachfolgende Kondensation zunächst zu Gelen umgesetzt und anschließend die erste und/oder zweite Metalloxid-Schicht durch Wärme und/oder elektromagnetische Strahlung ausgebildet.

In einigen Ausführungsformen werden die Metalloxid-Präkursoren und die wässrige Phase erst beim Aufbringen miteinander in Kontakt gebracht oder nacheinander aufgebracht. Entsprechend können die erfindungsgemäße erste und/oder zweite Phase auch erst auf einem Träger hergestellt und dadurch gleichzeitig aufgebracht werden. Dies kann günstig sein, insbesondere bei Sol-Gel-Verfahren, um besonders dünne und homogene Schichten zu erzeugen. Dadurch können Inhomogenitäten in den Metalloxid-Schichten vermieden und somit verhindert werden, dass die Metalloxid-Schichten schlechte Schicht-Parameter aufweisen. Unter einer Inhomogenität wird im vorliegenden Fall eine Kristallbildung in einzelnen Domänen verstanden, die an der Oberfläche zu Rauigkeiten von über Rms = 5 nm (quadratische Rauheit; englisch rms-roughness = root-mean-squared roughness: Wurzel des Mittelquadrates; gemessen über Atomic Force Microscopy) führt. Diese Rauigkeit wirkt sich zum einen nachteilig auf die Schichteigenschaften der Indiumoxidhaltigen Schicht (es resultieren vor allem zu geringe Ladungsträgerbeweglichkeiten für Halbleiter-Anwendungen) und zum anderen nachteilig für das Aufbringen weiterer Schichten zur Erzeugung eines Bauteils aus.

In einigen Ausführungsformen des Verfahrens umfassen die erste und/oder die zweite flüssige Phase mindestens ein Metalloxid vom Typus eines Metalloxid-Partikels. Bei den Metalloxid-Partikeln handelt es sich zumeist Nanopartikel. "Nanopartikel", wie hierin verwendet, bezeichnet Partikel mit einem Durchmesser von bis zu 100 nm, vorzugsweise im Bereich 1-100 nm. Zur Verwendung in dem vorliegenden Verfahren liegen solche Metalloxid-Partikel meist in einer druckbaren Dispersion vor. Zur Verbesserung dieser Eigenschaften kann die flüssige Phase ferner Dispergieradditive umfassen. Die flüssige Phase kann nach den oben beschriebenen Verfahren in eine feste Phase überführt werden, d.h. durch Wärmebehandlung und/oder elektromagnetische Strahlung, und dadurch die Metalloxid-Partikel abgeschieden werden. In manchen Ausführungsformen wird nach dem Druckvorgang die Metalloxid-Schicht durch einen Sintervorgang in eine Halbleiterschicht konvertiert.

In einem weiteren Aspekt betrifft die vorliegende Erfindung ein Halbleiterlaminat, das nach einem Verfahren der vorliegenden Erfindung hergestellt wird.

Ferner umfasst die vorliegende Erfindung ein elektronisches Bauteil, das ein Halbleiterlaminat der vorliegenden Erfindung umfasst.

Ebenfalls Teil der vorliegenden Erfindung ist ein elektronisches Bauteil, das ein Halbleiterlaminat der vorliegenden Erfindung umfasst, wobei das elektronische Bauteil ausgewählt wird aus der Gruppe bestehend aus einem Transistor, einem Dünnschichttransistor, einer Diode, einer Solarzelle, einem Sensor, einem RFID-Tag oder einem TFT-Backpanel für Bildschirme.

Ein weiterer Aspekt der Erfindung sind Verfahren zur Herstellung eines elektronischen Bauteils, wobei diese Verfahren die erfindungsgemäßen Verfahren zur Herstellung eines Halbleiterlaminats umfassen. Ebenso fällt die Verwendung eines erfindungsgemäßen Halbleiterlaminats zur Herstellung eines elektronischen Bauteils in den Umfang der vorliegenden Erfindung.

Solche elektronischen Bauteile werden nicht abschließend ausgewählt aus der Gruppe bestehend aus einem Transistor, einem Dünnschichttransistor, einer Diode, einer Solarzelle, einem Sensor, einem RFID-Tag oder einem TFT-Backpanel für Bildschirme.

**Ausführungsformen**

Beispiel 1: Herstellung von Halbleiterlaminaten

Es wurde ein dotiertes Siliziumsubstrat mit einer Kantenlänge von etwa 15 mm und mit einer ca. 200 nm dicken Siliziumoxid-Beschichtung und Fingerstrukturen aus ITO/Gold verwendet.

Es wurde eine Formulierung aus einem Indium-Präkursor (5 Gew.-% Lösung von $[In_5(\mu_5\text{-}O)(\mu_3\text{-}O^ir)_4(\mu_2\text{-}^iPr)_4(O^iPr)_5]$ in 1-Methoxy-2-Propanol) mittels Spin-Coating (2000 rp/m; 30 Sekunden) auf das Siliziumoxid aufgebracht.

Die Umwandlung der Präkursor-Schicht in die $In_2O_3$-Halbleiterschicht (erste Metalloxid-Schicht) mit einer Schichtdicke zwischen 1-20 nm Schichtdicke erfolgte mittels

    a. UV-Vernetzung (10 min UV Behandlung), gefolgt von
    b. Wärmebehandlung (1h bei 350 °C an der Luft).

Anschließend wurde eine weitere Formulierung aus einem Metalloxid-Präkursor oder Präkusorgemisch in organischem Lösungsmittel mittels Spin-Coating auf die $In_2O_3$-Halbleiterschicht aufgebracht. Die Umwandlung der Präkursor-Schicht in die zweite Metalloxid-Schicht erfolgte durch

    c. UV-Vernetzung (10min UV Behandlung), gefolgt von einer
    d. Wärmebehandlung (1h bei 350 °C an der Luft).

Die Ladungsträgerbeweglichkeit und der Onset-Shift wurden für verschiedene Kombinationen einer ersten $In_2O_3$-Metalloxid-Schicht mit verschiedenen Metalloxiden/Metalloxidkombinationen in der zweiten Metalloxid-Schicht bestimmt. Dabei deutet ein geringer Onset-Shift auf eine hohe elektrische Stabilität des Halbleiters.

Die verwendeten Stress-Parameter zur Bestimmung des Onset-Shifts waren: $U_{DS} = 10$ V und $U_{GS} = -20$ V (Negative Bias Stress Test). Die Messungen zur Stabilität wurden unter inerten Bedingungen ($N_2$) durchgeführt, um den Einfluss der atmosphärischen Gase auszuschließen.

Ergebnis:

| zweite Schicht | Ladungsträgerbeweglichkeit | Onset-Shift nach 100 Sek. Stress | Onset-Shift nach 200 Sek. Stress |
|---|---|---|---|
| keine | 12,6 | -2 | -4 |
| Zn-Oxid | 15,9 | -0,5 | -1,25 |
| Ga-Oxid | 12 | -0,5 | -0,75 |
| Hafnium-Oxid | 12 | 0 | 0 |
| Siliziumoxid | 13 | -0,25 | -0,25 |

(fortgesetzt)

| zweite Schicht | Ladungsträgerbeweglichkeit | Onset-Shift nach 100 Sek. Stress | Onset-Shift nach 200 Sek. Stress |
|---|---|---|---|
| Si+Ga Oxid | 12 | 0 | 0,25 |
| Si+Hf Oxid | 12 | 0 | 0 |

Die Ergebnisse zeigen, dass durch das Ausbilden einer zweiten Metalloxid-Schicht auf einer dünnen ersten halbleitenden Metalloxid-Schicht eine Stabilisierung gegen elektrischen Stress erzielt wird, ohne gleichzeitig die Ladungsträgerbeweglichkeit zu reduzieren.

Beispiel 2: Vergleichsbeispiel (Einmischen von Metallatomen)

Das Vergleichsbeispiel wurde wie in Beispiel 1 durchgeführt, mit der Ausnahme, dass nun keine zweite Metalloxid-Schicht auf der ersten Metalloxid-Schicht ausgebildet wurde. Stattdessen wurden der ersten flüssigen Phase, die Indium-Präkursor enthielt, verschiedene Mengen an Zink-Präkursor beigemischt. Die Ladungsträgerbeweglichkeit des Halbleiters mit nur einer Metalloxid-Schicht wurde untersucht. Es zeigte sich, dass schon wenige Prozente an Zink-Präkursor in der ersten flüssigen Phase zu einer drastischen Absenkung der Ladungsträgerbeweglichkeit führen (Vergl. Figur 3).

**Patentansprüche**

1. Verfahren zur Herstellung eines Halbleiterlaminats umfassend
eine erste Metalloxid-Schicht, eine zweite Metalloxid-Schicht und eine Dielektrikum-Schicht, wobei die erste Metalloxid-Schicht zwischen der zweiten Metalloxid-Schicht und der Dielektrikum-Schicht angeordnet ist, wobei das Verfahren umfasst:

Ausbilden einer ersten Metalloxid-Schicht enthaltend mindestens ein Metalloxid ausgewählt aus der Gruppe bestehend aus Indiumoxid, Galliumoxid, Zinkoxid, Zinnoxid oder Mischungen davon aus einer ersten flüssigen Phase, wobei die erste Metalloxid-Schicht eine Schichtdicke von ≤ 20 nm aufweist und die erste flüssige Phase mindestens ein Metalloxid oder mindestens einen Metalloxid-Präkursor enthält, wobei das Metalloxid ausgewählt wird aus der Gruppe bestehend aus Indiumoxid, Galliumoxid, Zinkoxid, Zinnoxid oder Mischungen davon, Ausbilden einer zweiten Metalloxid-Schicht enthaltend mindestens ein Metalloxid ausgewählt aus der Gruppe bestehend aus Galliumoxid, Zinkoxid, Zinnoxid, Hafniumoxid, Siliziumoxid, Aluminiumoxid, Titanoxid, Alkalimetalloxiden, Erdalkalimetalloxiden oder Mischungen davon aus einer zweiten flüssigen Phase, wobei die zweite flüssige Phase mindestens ein Metalloxid oder mindestens einen Metalloxid-Präkursor enthält, wobei das Metalloxid ausgewählt wird aus der Gruppe bestehend aus Galliumoxid, Zinkoxid, Zinnoxid, Hafniumoxid, Siliziumoxid, Aluminiumoxid, Titanoxid, Alkalimetalloxiden, Erdalkalimetalloxiden oder Mischungen davon, wobei das mindestens eine Metalloxid der ersten Schicht und das mindestens eine Metalloxid der zweiten Schicht unterschiedlich sind.

2. Das Verfahren gemäß Anspruch 1, wobei die erste Metalloxid-Schicht eine Schichtdicke von 0,5-20 nm aufweist.

3. Das Verfahren gemäß Anspruch 1 oder 2, wobei die zweite Metalloxid-Schicht mindestens die Schichtdicke der ersten Metalloxid-Schicht aufweist.

4. Das Verfahren gemäß einem der Ansprüche 1-3, wobei die zweite Metalloxid-Schicht mindestens ein Metalloxid umfasst, das nicht in der ersten Metalloxid-Schicht enthalten ist.

5. Das Verfahren nach einem der Ansprüche 1-4, wobei die zweite Metalloxid-Schicht mindestens zwei Metalloxide umfasst.

6. Das Verfahren nach einem der Ansprüche 1-5, wobei die erste Metalloxid-Schicht mindestens zwei Metalloxide umfasst.

7. Das Verfahren nach einem der Ansprüche 1-6, wobei die zweite Metalloxid-Schicht Siliziumoxid umfasst.

**8.** Das Verfahren nach einem der Ansprüche 1-7, wobei die erste Metalloxid-Schicht im Wesentlichen aus Indiumoxid ($In_2O_3$) oder Indium-Gallium-Oxid besteht.

**9.** Das Verfahren nach einem der Ansprüche 1-8 wobei die zweite Metalloxid-Schicht im Wesentlichen aus ZnO, $Ga_2O_3$, $HfO_2$, $SiO_2$, Silizium-Gallium-Oxid oder Silizium-Hafnium-Oxid besteht.

**10.** Das Verfahren nach einem der Ansprüche 1-9, wobei das Ausbilden der ersten Metalloxid-Schicht umfasst:

Aufbringen der ersten flüssigen Phase auf die Dielektrikum-Schicht, und
Abscheiden des mindestens einen Metalloxids oder des mindestens einen Metalloxid-Präkursors der ersten flüssigen Phase auf der Dielektrikum-Schicht, um die erste Metalloxid-Schicht auf der Dielektrikum-Schicht auszubilden,
und wobei das Ausbilden der zweiten Metalloxid-Schicht umfasst:

Aufbringen der zweiten flüssigen Phase auf die erste Metalloxid-Schicht, und
Abscheiden des mindestens einen Metalloxids oder des mindestens einen Metalloxid-Präkursors der zweiten flüssigen Phase auf der ersten Metalloxid-Schicht, um die zweite Metalloxid-Schicht auf der ersten Metalloxid-Schicht auszubilden.

**11.** Das Verfahren nach einem der Ansprüche 1-10, wobei das Ausbilden der zweiten Metalloxid-Schicht umfasst:

Aufbringen der zweiten flüssigen Phase auf einem Substrat, und
Abscheiden des mindestens einen Metalloxids oder des mindestens einen Metalloxid-Präkursors der zweiten flüssigen Phase auf dem Substrat, um die zweite Metalloxid-Schicht auf dem Substrat auszubilden,
und wobei das Ausbilden der ersten Metalloxid-Schicht umfasst:

Aufbringen der ersten flüssigen Phase auf die zweite Metalloxid-Schicht, und
Abscheiden des mindestens einen Metalloxids oder der mindestens einen Metalloxid-Präkursors der ersten flüssigen Phase auf der zweiten Metalloxidschicht, um die erste Metalloxid-Schicht auf der zweiten Metalloxid-Schicht auszubilden, und
Aufbringen der Dielektrikum-Schicht auf die erste Metalloxid-Schicht.

**12.** Das Verfahren nach einem der Ansprüche 1-11, wobei die erste und/oder die zweite flüssige Phase durch Verfahren aufgebracht werden, die ausgewählt werden aus der Gruppe bestehend aus Druckverfahren, Sprühverfahren, Rotationsbeschichtungsverfahren, Tauchverfahren und Slot-Die Coating.

**13.** Das Verfahren gemäß einem der Ansprüche 1-12, wobei der mindestens eine Metalloxid-Präkursor der ersten und/oder zweiten flüssigen Phase aus der Klasse der Metall-Alkoxide und/oder Metall-Oxoalkoxide stammt.

**14.** Das Verfahren nach Anspruch 13, wobei die erste und/oder die zweite flüssige Phase mindestens ein organisches Lösungsmittel umfassen.

**15.** Das Verfahren nach Anspruch 14, wobei das organische Lösungsmittel im Wesentlichen wasserfrei ist.

**16.** Das Verfahren nach einem der Ansprüche 1-12, wobei die erste und/oder die zweite flüssige Phase mindestens ein Metalloxid vom Typus eines Metalloxid-Partikels umfassen.

**17.** Das Verfahren nach einem der Ansprüche 1-13 oder 16, wobei die erste und/oder die zweite flüssige Phase eine wässrige Phase umfassen.

**18.** Das Verfahren nach einem der Ansprüche 1-17, wobei das Ausbilden der ersten und/oder zweiten Metalloxid-Schicht ferner eine Wärmebehandlung der ersten und/oder zweiten flüssigen Phase umfasst.

**19.** Das Verfahren nach einem der Ansprüche 1-18, wobei das Ausbilden der ersten und/oder zweiten Metalloxid-Schicht die Bestrahlung der ersten und/oder zweiten flüssigen Phase mit elektromagnetischer Strahlung, insbesondere UV-, IR-, VIS-Strahlung, umfasst, wobei insbesondere vor, nach oder während einer Wärmebehandlung der ersten und/oder zweiten flüssigen Phase die erste und/oder zweite flüssigen Phase mit UV-Strahlung bestrahlt werden.

**20.** Das Verfahren nach einem der Ansprüche 1-19, wobei die erste und/oder die zweite Metalloxid-Schicht unter sauerstoffhaltiger Atmosphäre, insbesondere Luft, ausgebildet werden.

**21.** Das Verfahren nach einem der Ansprüche 18-20, wobei die erste und/oder die zweite Metalloxid-Schicht bei einer Temperatur von 100-450°C, bevorzugt bei 150-350 °C wärmebehandelt werden.

**22.** Das Verfahren nach einem der Ansprüche 1-21, wobei die erste Metalloxid-Schicht eine Schichtdicke von 0,5-10 nm, bevorzugt 2-5 nm aufweist.

**Claims**

**1.** Process for producing a semiconductor laminate comprising a first metal oxide layer, a second metal oxide layer and a dielectric layer, the first metal oxide layer being arranged between the second metal oxide layer and the dielectric layer, and the process comprising:

forming a first metal oxide layer comprising at least one metal oxide selected from the group consisting of indium oxide, gallium oxide, zinc oxide, tin oxide or mixtures thereof from a first liquid phase, the first metal oxide layer having a layer thickness of $\leq$ 20 nm and the first liquid phase comprising at least one metal oxide or at least one metal oxide precursor, the metal oxide being selected from the group consisting of indium oxide, gallium oxide, zinc oxide, tin oxide or mixtures thereof,
forming a second metal oxide layer comprising at least one metal oxide selected from the group consisting of gallium oxide, zinc oxide, tin oxide, hafnium oxide, silicon oxide, aluminium oxide, titanium oxide, alkali metal oxides, alkaline earth metal oxides or mixtures thereof from a second liquid phase, the second liquid phase comprising at least one metal oxide or at least one metal oxide precursor, the metal oxide being selected from the group consisting of gallium oxide, zinc oxide, tin oxide, hafnium oxide, silicon oxide, aluminium oxide, titanium oxide, alkali metal oxides, alkaline earth metal oxides or mixtures thereof,
the at least one metal oxide of the first layer and the at least one metal oxide of the second layer being different.

**2.** Process according to Claim 1, wherein the first metal oxide layer has a layer thickness of 0.5-20 nm.

**3.** Process according to Claim 1 or 2, wherein the second metal oxide layer has at least the layer thickness of the first metal oxide layer.

**4.** Process according to any of Claims 1-3, wherein the second metal oxide layer comprises at least one metal oxide not present in the first metal oxide layer.

**5.** Process according to any of Claims 1-4, wherein the second metal oxide layer comprises at least two metal oxides.

**6.** Process according to any of Claims 1-5, wherein the first metal oxide layer comprises at least two metal oxides.

**7.** Process according to any of Claims 1-6, wherein the second metal oxide layer comprises silicon oxide.

**8.** Process according to any of Claims 1-7, wherein the first metal oxide layer consists essentially of indium oxide ($In_2O_3$) or indium gallium oxide.

**9.** Process according to any of Claims 1-8, wherein the second metal oxide layer consists essentially of ZnO, $Ga_2O_3$, $HfO_2$, $SiO_2$, silicon gallium oxide or silicon hafnium oxide.

**10.** Process according to any of Claims 1-9, wherein the forming of the first metal oxide layer comprises:

applying the first liquid phase to the dielectric layer, and
depositing the at least one metal oxide or the at least one metal oxide precursor of the first liquid phase on the dielectric layer in order to form the first metal oxide layer on the dielectric layer,
and wherein the forming of the second metal oxide layer comprises:

applying the second liquid phase to the first metal oxide layer, and
depositing the at least one metal oxide or the at least one metal oxide precursor of the second liquid phase on the first metal oxide layer in order to form the second metal oxide layer on the first metal oxide layer.

11. Process according to any of Claims 1-10, wherein the forming of the second metal oxide layer comprises:

applying the second liquid phase on a substrate, and
depositing the at least one metal oxide or the at least one metal oxide precursor of the second liquid phase on the substrate in order to form the second metal oxide layer on the substrate,
and wherein the forming of the first metal oxide layer comprises:

applying the first liquid phase to the second metal oxide layer, and
depositing the at least one metal oxide or the at least one metal oxide precursor of the first liquid phase on the second metal oxide layer in order to form the first metal oxide layer on the second metal oxide layer, and

applying the dielectric layer to the first metal oxide layer.

12. Process according to any of Claims 1-11, wherein the first and/or second liquid phase are applied by processes selected from the group consisting of printing processes, spraying processes, rotary coating processes, dipping processes and slot-die coating.

13. Process according to any of Claims 1-12, wherein the at least one metal oxide precursor of the first and/or second liquid phase originates from the class of the metal alkoxides and/or metal oxo alkoxides.

14. Process according to Claim 13, wherein the first and/or second liquid phase comprise at least one organic solvent.

15. Process according to Claim 14, wherein the organic solvent is essentially anhydrous.

16. Process according to any of Claims 1-12, wherein the first and/or second liquid phase comprise at least one metal oxide of the metal oxide particle type.

17. Process according to any of Claims 1-13 or 16, wherein the first and/or second liquid phase comprise an aqueous phase.

18. Process according to any of Claims 1-17, wherein the forming of the first and/or second metal oxide layer further comprises a heat treatment of the first and/or second liquid phase.

19. Process according to any of Claims 1-18, wherein the forming of the first and/or second metal oxide layer comprises the irradiation of the first and/or second liquid phase with electromagnetic radiation, especially UV, IR, VIS radiation, more particularly with irradiation of the first and/or second liquid phase with UV radiation before, after or during a heat treatment of the first and/or second liquid phase.

20. Process according to any of Claims 1-19, wherein the first and/or second metal oxide layer are formed under an oxygenous atmosphere, especially air.

21. Process according to any of Claims 18-20, wherein the first and/or second metal oxide layer are heat-treated at a temperature of 100-450°C, preferably at 150-350°C.

22. Process according to any of Claims 1-21, wherein the first metal oxide layer has a layer thickness of 0.5-10 nm, preferably 2-5 nm.

**Revendications**

1. Procédé de fabrication d'un stratifié semiconducteur, comprenant :

une première couche d'oxyde métallique, une deuxième couche d'oxyde métallique et une couche diélectrique, la première couche d'oxyde métallique étant agencée entre la deuxième couche d'oxyde métallique et la couche diélectrique,
le procédé comprenant :

la formation d'une première couche d'oxyde métallique contenant au moins un oxyde métallique choisi dans le groupe constitué par l'oxyde d'indium, l'oxyde de gallium, l'oxyde de zinc, l'oxyde d'étain ou leurs mélanges à partir d'une première phase liquide, la première couche d'oxyde métallique présentant une épaisseur de couche ≤ 20 nm et la première phase liquide contenant au moins un oxyde métallique ou au moins un précurseur d'oxyde métallique, l'oxyde métallique étant choisi dans le groupe constitué par l'oxyde d'indium, l'oxyde de gallium, l'oxyde de zinc, l'oxyde d'étain ou leurs mélanges,

la formation d'une deuxième couche d'oxyde métallique contenant au moins un oxyde métallique choisi dans le groupe constitué par l'oxyde de gallium, l'oxyde de zinc, l'oxyde d'étain, l'oxyde d'hafnium, l'oxyde de silicium, l'oxyde d'aluminium, l'oxyde de titane, les oxydes de métaux alcalins, les oxydes de métaux alcalino-terreux ou leurs mélanges à partir d'une deuxième phase liquide, la deuxième phase liquide contenant au moins un oxyde métallique ou au moins un précurseur d'oxyde métallique, l'oxyde métallique étant choisi dans le groupe constitué par l'oxyde de gallium, l'oxyde de zinc, l'oxyde d'étain, l'oxyde d'hafnium, l'oxyde de silicium, l'oxyde d'aluminium, l'oxyde de titane, les oxydes de métaux alcalins, les oxydes de métaux alcalino-terreux ou leurs mélanges, ledit au moins un oxyde métallique de la première couche et ledit au moins oxyde métallique de la deuxième couche étant différents.

2.  Procédé selon la revendication 1, dans lequel la première couche d'oxyde métallique présente une épaisseur de couche de 0,5 à 20 nm.

3.  Procédé selon la revendication 1 ou 2, dans lequel la deuxième couche d'oxyde métallique présente au moins l'épaisseur de couche de la première couche d'oxyde métallique.

4.  Procédé selon l'une quelconque des revendications 1 à 3, dans lequel la deuxième couche d'oxyde métallique comprend au moins un oxyde métallique qui n'est pas contenu dans la première couche d'oxyde métallique.

5.  Procédé selon l'une quelconque des revendications 1 à 4, dans lequel la deuxième couche d'oxyde métallique comprend au moins deux oxydes métalliques.

6.  Procédé selon l'une quelconque des revendications 1 à 5, dans lequel la première couche d'oxyde métallique comprend au moins deux oxydes métalliques.

7.  Procédé selon l'une quelconque des revendications 1 à 6, dans lequel la deuxième couche d'oxyde métallique comprend de l'oxyde de silicium.

8.  Procédé selon l'une quelconque des revendications 1 à 7, dans lequel la première couche d'oxyde métallique est essentiellement constituée d'oxyde d'indium ($In_2O_3$) ou d'oxyde d'indium et de gallium.

9.  Procédé selon l'une quelconque des revendications 1 à 8, dans lequel la deuxième couche d'oxyde métallique est essentiellement constituée de ZnO, $Ga_2O_3$, $HfO_2$, $SiO_2$, d'oxyde de silicium et de gallium ou d'oxyde de silicium et d'hafnium.

10. Procédé selon l'une quelconque des revendications 1 à 9, dans lequel la formation de la première couche d'oxyde métallique comprend :

    l'application de la première phase liquide sur la couche diélectrique et
    le dépôt dudit au moins un oxyde métallique ou dudit au moins un précurseur d'oxyde métallique de la première phase liquide sur la couche diélectrique, afin de former la première couche d'oxyde métallique sur la couche diélectrique,
    et dans lequel la formation de la deuxième couche d'oxyde métallique comprend :

    l'application de la deuxième phase liquide sur la première couche d'oxyde métallique, et
    le dépôt dudit au moins un oxyde métallique ou dudit au moins un précurseur d'oxyde métallique de la deuxième phase liquide sur la première couche d'oxyde métallique, afin de former la deuxième couche d'oxyde métallique sur la première couche d'oxyde métallique.

11. Procédé selon l'une quelconque des revendications 1 à 10, dans lequel la formation de la deuxième couche d'oxyde métallique comprend :

l'application de la deuxième phase liquide sur un substrat et
le dépôt dudit au moins un oxyde métallique ou dudit au moins un précurseur d'oxyde métallique de la deuxième phase liquide sur le substrat, afin de former la deuxième couche d'oxyde métallique sur le substrat, et dans lequel la formation de la première couche d'oxyde métallique comprend :

l'application de la première phase liquide sur la deuxième couche d'oxyde métallique, et
le dépôt dudit au moins un oxyde métallique ou dudit au moins un précurseur d'oxyde métallique de la première phase liquide sur la deuxième couche d'oxyde métallique, afin de former la première couche d'oxyde métallique sur la deuxième couche d'oxyde métallique, et

l'application de la couche diélectrique sur la première couche d'oxyde métallique.

12. Procédé selon l'une quelconque des revendications 1 à 11, dans lequel la première et/ou la deuxième phase liquide sont appliquées par des procédés qui sont choisis dans le groupe constitué par les procédés d'impression, les procédés de pulvérisation, les procédés de revêtement par rotation, les procédés d'immersion et le revêtement par filière droite plate.

13. Procédé selon l'une quelconque des revendications 1 à 12, dans lequel ledit au moins un précurseur d'oxyde métallique de la première et/ou de la deuxième phase liquide provient de la classe des alcoxydes métalliques et/ou des oxoalcoxydes métalliques.

14. Procédé selon la revendication 13, dans lequel la première et/ou la deuxième phase liquide comprennent au moins un solvant organique.

15. Procédé selon la revendication 14, dans lequel le solvant organique est essentiellement anhydre.

16. Procédé selon l'une quelconque des revendications 1 à 12, dans lequel la première et/ou la deuxième phase liquide comprennent au moins un oxyde métallique du type d'une particule d'oxyde métallique.

17. Procédé selon l'une quelconque des revendications 1 à 13 ou 16, dans lequel la première et/ou la deuxième phase liquide comprennent une phase aqueuse.

18. Procédé selon l'une quelconque des revendications 1 à 17, dans lequel la formation de la première et/ou de la deuxième couche d'oxyde métallique comprend en outre un traitement thermique de la première et/ou de la deuxième phase liquide.

19. Procédé selon l'une quelconque des revendications 1 à 18, dans lequel la formation de la première et/ou de la deuxième couche d'oxyde métallique comprend l'exposition de la première et/ou de la deuxième phase liquide à un rayonnement électromagnétique, notamment à un rayonnement UV, IR, VIS, la première et/ou la deuxième phase liquide étant notamment exposées à un rayonnement UV avant, après ou pendant un traitement thermique de la première et/ou de la deuxième phase liquide.

20. Procédé selon l'une quelconque des revendications 1 à 19, dans lequel la première et/ou la deuxième couche d'oxyde métallique sont formées sous une atmosphère contenant de l'oxygène, notamment de l'air.

21. Procédé selon l'une quelconque des revendications 18 à 20, dans lequel la première et/ou la deuxième couche d'oxyde métallique sont traitées thermiquement à une température de 100 à 450 °C, de préférence de 150 à 350 °C.

22. Procédé selon l'une quelconque des revendications 1 à 21, dans lequel la première couche d'oxyde métallique présente une épaisseur de couche de 0,5 à 10 nm, de préférence de 2 à 5 nm.

Figur 1

Figur 2

Figur 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2007073704 A
- WO 2010122274 A1
- US 20060088962 A1
- WO 2006049791 A1
- WO 2010094583 A1

- WO 2011020792 A1
- JP 6136162 A
- JP 9157855 A
- CN 1280960 A


**In der Beschreibung aufgeführte Nicht-Patentliteratur**

- **HONG et al.** *Thin Solid Films,* 2006, vol. 515, 2717-2721
- **SONG et al.** *Solid State Communications,* 2010, vol. 150, 1991-1994
- **KUMOMI et al.** *Journal of Display Technology,* 2009, vol. 5 (12), 531-540
- **KIM et al.** *APPLIED PHYSICS LETTERS,* 2010, vol. 96, 163506
- **OHYA Y et al.** FABRICATION OF ZINC OXIDE TRANSPARENT THIN-FILM TRANSISTOR WITH ZRO2 INSULATING LAYER BY SOL-GEL METHOD. *JAPANESE JOURNAL OF APPLIED PHYSICS,* 01. April 2005, vol. 44 (4A), 1919-1922

- Infrared Ellipsometry on semiconductor layer struc-tures. **M. SCHUBERT.** Phonons, Plasmons, and Po-laritons. Springer Tracts in Modern Physics 209, Springer-Verlag, 2004
- **G. BINNIG ; C. F. QUATE ; C. GERBER.** Atomic force microscope. *Physical Review Letters,* 1986, vol. 56, 930-933
- **KIM et al.** *J. Am. Chem. Soc.,* 2008, vol. 130, 12580-12581